# NEUE EUROPÄISCHE PATENTSCHRIFT

(11) **EP 2 144 296 B2**
(45) Veröffentlichungstag und Bekanntmachung des Hinweises auf die Entscheidung über den Einspruch: **17.01.2018**
(45) Hinweis auf die Patenterteilung: 02.04.2014
(21) Anmeldenummer: 08020746.7
(22) Anmeldetag: 28.11.2008
(51) Int. Cl.: H01L 31/032

(54) **Verfahren zum Herstellen einer Halbleiterschicht**
Method for manufacturing a semiconductive layer
Procédé de fabrication d'une couche semi-conductrice

(30) Priorität: 20.06.2008 EP 08011247
(43) Veröffentlichungstag der Anmeldung: 13.01.2010
(73) Patentinhaber: Probst, Volker, 14089 Berlin (DE)
(72) Erfinder: Probst, Volker, 14089 Berlin (DE)
(74) Vertreter: Metten, Karl-Heinz

(56) Entgegenhaltungen:
- EP-A1- 0 195 152
- EP-A1- 1 833 097
- WO-A2-2005/017978
- DE-A1- 19 717 565
- DE-A1-102004 024 601
- DE-A1-102004 048 310
- DE-C1- 19 611 996
- US-A- 5 015 503
- US-A- 5 045 409
- US-A- 6 117 703
- US-A1- 2008 072 962
- US-B1- 6 302 684
- US-B2- 7 204 885
- KOSARAJU S ET AL: "Formation of chalcogen containing plasmas and their use in the synthesis of photovoltaic absorbers" JOURNAL OF VACUUM SCIENCE AND TECHNOLOGY: PART A, AVS /AIP, MELVILLE, NY., US, Bd. 23, Nr. 4, 28. Juni 2005 (2005-06-28), Seiten 1202-1207, XP012074040 ISSN: 0734-2101
- LAKSHMIKUMAR S T ET AL: "SELENIZATION OF CU AND IN THIN FILMS FOR THE PREPARATION OF SELENIDE PHOTO-ABSORBER LAYERS IN SOLAR CELLS USING SE VAPOUR SOURCE" SOLAR ENERGY MATERIALS AND SOLAR CELLS, ELSEVIER SCIENCE PUBLISHERS, AMSTERDAM, NL, Bd. 32, Nr. 1, 1. Januar 1994 (1994-01-01), Seiten 7-19, XP000423312 ISSN: 0927-0248
- OHASHI, D ET AL: 'Improved CIGS thin-film solar cells fy surface sulfurization' SOLAR ENERGY MATERIALS & SOLAR CELLS Bd. 67, 2001, Seiten 201 - 265
- PROBST, V. ET AL: 'Rapid CIS-process for high efficiency PV-modules: development towards large area processing' THIN SOLID FILMS Bd. 387, 2001, Seiten 262 - 267
- PALM, J. ET AL: 'CIS module pilot processing applying concurrent rapid selenization and sulfurization of large area thin film precursors' THIN SOLID FILMS Bd. 431-432, 2003, Seiten 514 - 522
- Umluftöfen optimieren Gefunden im Internet: <URL:www.scope-online.de/>
- Erzwungene Konvektion erhöht Prozessqualität Gefunden im Internet: <URL:www.scope-online.de/>
- LINN HIGH THERM vol. 'Industrieofen'
- ORBEY, N. ET AL: 'Reaction Analysis of the Formation of CuInSe2 Films in a Physical Vapor Deposition Reactor' PROG.PHOTOVOLT.RES.APPL. Bd. 6, 1998, Seiten 79 - 86
- ROMEO, A. ET AL: 'Development of Thin-film Cu (In,Ga)Se2 and CdTe Solar Cells' PROG.PHOTOVOLT.RES.APPL. Bd. 12, 2004, Seiten 93 - 111
- ADURODIJA, F.O. ET AL: 'Growth of CuInSe2 thin films by high vapour Se treatment of co-sputtered Cu-In alloy in a graphite container' THIN SOLID FILMS Bd. 338, 1999, Seiten 13 - 19
- KUSHIYA, K. ET AL: 'The role of Cu(inGa(SeS)2 surface layer on a graded band-gap Cu(InGa)Se2 thin-film solar cell prepared by two-stage method' 25TH PVSC 1996, Seiten 989 - 992
- NAGOYA, Y ET AL: 'Role of incorporated sulfur into the surface of Cu(InGa)Se2 thin-film absorber' SOLAR ENERGY MATERIALS & SOLAR CELLS Bd. 67, 2001, Seiten 247 - 253
- DROTT, E: 'Elektrisch beheizte Umluftöfen für die Wärmebehandlung von Metallen' METALL Nr. 59, 2005, Seiten 801 - 805

## Beschreibung

Die Erfindung betrifft ein Verfahren zum Herstellen einer Halbleiterschicht, bei dem wenigstens ein mit einer Metallschicht versehenes Substrat und insbesondere ein Stapel von jeweils mit einer Metallschicht versehenen Substraten in einer Prozesskammer eingebracht und auf eine vorbestimmte Substrattemperatur erwärmt wird.

Ein derartiges Verfahren ist grundsätzlich bekannt und kommt beispielsweise in der Solarzellenindustrie bei der Herstellung von CIS-Solarzellen zum Einsatz. Insbesondere wird ein bekanntes Verfahren dieser Art zur Herstellung von I-III-VI-Verbindungs-Halbleiterschichten, so genannten Chalcopyrit-Halbleiterschichten, verwendet. Hierzu werden beispielsweise eine Molybdän-Dünnschicht aufweisende Substrate, z.B. Glassubstrate jeweils mit einer Kupfer, Gallium und Indium umfassenden Precursormetall-Dünnschicht versehen und anschließend in der Prozesskammer unter Zufuhr von H₂Se und H₂S gemäß einem vorgegebenen Temperaturprofil erwärmt. In einer Variante werden eine Molybdän-Dünnschicht aufweisende Substrate jeweils mit einer Kupfer, Gallium, Indium und Selen umfassenden Precursormetall-Dünnschicht versehen und anschließend in der Prozesskammer unter Zufuhr von H₂S gemäß einem vorgegebenen Temperaturprofil erwärmt. Durch eine Reaktion der Precursormetallschichten mit dem in dem H₂Se enthaltenen Selen bzw. dem in dem H₂S enthaltenden Schwefel bilden sich auf den Substraten Cu(In,Ga)(Se,S)₂-Halbleiterschichten, so genannte Chalcopyrit-Halbleiterschichten, aus.

Dieser Prozess wird auch als Selenisierung bzw. Sulphurisierung bezeichnet.

EP 1 833 097 offenbart ein Verfahren und eine Vorrichtung zur Selenisierung bzw. Sulphurisierung von Werkstücken, wobei die Reaktionsgase mittels eines Ventilators umgewirbelt werden.

Die Verwendung von H₂Se und H₂S erweist sich insofern als problematisch, als dass H₂Se und H₂S nicht nur in der Anschaffung teure, sondern auch toxische und hochexplosive Gase sind. Diese Gase stellen in der Massenfertigung von CIS-Solarzellen also nicht nur aufgrund ihrer Anschaffungskosten, sondern auch wegen der zu treffenden erhöhten Sicherheitsvorkehrungen und der mit der Entsorgung der entsprechenden Auspuffgase verbundenen Kosten einen erheblichen wirtschaftlichen Faktor dar. Davon abgesehen bilden diese Gase aufgrund ihrer Toxizität und Explosivität auch trotz getroffener Vorsichtsmassnahmen ein nicht zu unterschätzendes Sicherheitsrestrisiko für das Fertigungspersonal.

Der Erfindung liegt die Aufgabe zugrunde, ein wirtschaftlicheres und sichereres Verfahren zum Herstellen einer Halbleiterschicht, insbesondere einer Chalcopyrit-Halbleiterschicht oder einer Pufferschicht auf einer Halbleiterschicht, zu schaffen.

Zur Lösung der Aufgabe ist ein Verfahren mit den Merkmalen des Anspruchs 1 vorgesehen.

Bei dem erfindungsgemäßen Verfahren wird wenigstens ein mit einer Metallschicht versehenes Substrat und insbesondere ein Stapel von jeweils mit einer Metallschicht versehenen Substraten in eine Prozesskammer eingebracht und auf eine vorbestimmte Substrattemperatur erwärmt. Das erfindungsgemäße Verfahren zeichnet sich auch dadurch aus, dass elementarer Selen- und/oder Schwefeldampf von einer, vorzugsweise außerhalb der Prozesskammer gelegenen Quelle, mittels eines, insbesondere inerten, Trägergases unter Grobvakuumbedingungen bis Überdruckbedingungen an der bzw. jeder Metallschicht vorbeigeleitet wird, um diese mit Selen bzw. Schwefel gezielt chemisch zu reagieren.

Als Grobvakuumbedingungen werden in diesem Kontext Prozessbedingungen bezeichnet, die bei Prozessdrücken von Umgebungsdruck bis 1 mbar herrschen. Das erfindungsgemäße Verfahren und die erfindungsgemäße Vorrichtung können grundsätzlich aber auch bei Überdruck angewendet werden.

Erfindungsgemäß wird das zur Reaktion mit der Metallschicht benötigte Selen bzw. der zur Reaktion mit der Metallschicht benötigte Schwefel somit nicht durch H₂Se- oder H₂S-Gas, sondern durch elementaren Selen- bzw. Schwefeldampf, d.h. also elementaren Selen enthaltenden Dampf bzw. elementaren Schwefel enthaltenden Dampf, bereitgestellt. Auf die Verwendung von H₂Se und H₂S wird erfindungsgemäß folglich verzichtet.

Im Gegensatz zu H₂Se und H₂S sind elementarer Selendampf und elementarer Schwefeldampf weder hochtoxisch, noch explosiv und somit wesentlich weniger gefährlich im Umgang, so dass auf aufwendige und kostspielige Sicherheitsvorkehrungen verzichtet werden kann. Darüber hinaus lassen sich elementarer Selendampf und elementarer Schwefeldampf auf einfache Weise z.B. aus einer Selen- bzw. Schwefelschmelze gewinnen. Im Ergebnis lässt ist das erfindungsgemäße Verfahren also mit einem wesentlich geringeren wirtschaftlichen Aufwand und mit einer deutlich höheren Sicherheit durchführbar.

Vorteilhafte Ausbildungen des Verfahrens sind den Unteransprüchen, der Beschreibung und der Zeichnung zu entnehmen.

Um einen gewünschten Dampfdruck des Selen- bzw. Schwefeldampfs zu erreichen, wird die Quelle vorzugsweise auf einer erhöhten Quellentemperatur gehalten. Dabei ist die Quellentemperatur vorzugsweise zu jedem Zeitpunkt des Vorbeileitens des elementaren Selen- und/oder Schwefeldampfs an dem Substrat kleiner als die Temperatur in der Prozesskammer und insbesondere kleiner als eine minimale Substrattemperatur. Hierdurch wird erreicht, dass in der Prozesskammer für jede Substrattemperatur gilt, dass der Partialdruck des Selens bzw. Schwefels kleiner als der Dampfdruck des Selens bzw. Schwefels bei der jeweiligen Substrattemperatur ist. Somit wird eine Kondensation des Selen- oder Schwefeldampfes auf dem Substrat vermieden, was eine wichtige Voraussetzung für eine homogene Reaktion zu einer Halbleiterschicht ist. Eine Kondensation beispielsweise von Selendampf auf dem Substrat würde nämlich eine Entnetzung des Selens und damit eine lateral inhomogene Schichtdickenverteilung des Selens und einen lateral inhomogenen Reaktionsablauf zur Folge haben.

Erfindungsgemäß wird das Substrat mittels erzwungener Konvektion erwärmt. Hierdurch wird erreicht, dass die Temperaturverteilung über das Substrat gesehen besonders homogen ist. Mit anderen Worten werden Temperaturschwankungen über das Substrat minimiert.

Erfindungsgemäß wird auch der elementare Selen- bzw. Schwefeldampf mittels erzwungener Konvektion an dem Substrat vorbeigeleitet, da hierdurch ein über die Fläche des Substrats gesehen besonders homogener Verlauf der Reaktion des Selens bzw. Schwefels mit der Metallschicht erreicht wird.

Gemäß einer weiteren Ausführungsform werden bzw. wird eine Zuführleitung, durch die der elementare Selen- und/oder Schwefeldampf auf dem Weg von der Quelle zu dem Substrat geleitet wird, und/oder eine die Prozesskammer definierende Wand auf einer Temperatur gehalten, die gleich oder größer als die Quellentemperatur ist. Hierdurch ist sichergestellt, dass der Selen- bzw. Schwefeldampf nicht an der Zuführleitung oder an der Prozesskammerwand kondensiert, sondern ausschließlich mit der auf dem Substrat befindlichen Metallschicht gezielt chemisch reagiert.

Als Quelle kann ein flüssiges Selen oder flüssigen Schwefel aufweisender Bubbler, durch den das Trägergas geleitet wird, oder ein mit flüssigem Selen oder Schwefel gefüllter Tiegel verwendet werden, welcher eine eine Verdampfung des Selens oder Schwefels ermöglichende Seite aufweist, an der das Trägergas vorbeigeleitet wird. Eine derartige Quelle zeichnet sich nicht nur durch einen einfachen und kostengünstigen Aufbau aus, sondern sie lässt sich auch in bereits bestehende Prozessanlagen integrieren, so dass sich bestehende Prozessanlagen auf einfache Weise zur Durchführung des erfindungsgemäßen Verfahrens nachrüsten lassen.

Vorteilhafterweise wird die chemische Reaktion des Selens und/oder Schwefels mit der Metallschicht, d.h. also die Selenisierung bzw. Sulphurisierung, bei einem Druck in der Prozesskammer im Bereich von etwa 1 mbar bis etwa 1030 mbar durchgeführt. Diese Prozessdrücke sind zum einen so niedrig, dass die Prozessgase, insbesondere der Selendampf bzw. Schwefeldampf, nicht aus der Prozesskammer entweichen können. Gleichzeitig sind diese Prozessdrücke aber so hoch, dass es sich bei den Prozessen nicht um Hoch- oder Feinvakuumprozesse im eigentlichen Sinne handelt. An die Vakuumtechnik und insbesondere an die Pumpleistung vorhandener Pumpen können somit geringere Anforderungen gestellt werden, wodurch sich das Verfahren insgesamt noch kostengünstiger durchführen lässt.

Sowohl der Selen- als auch der Schwefeldampfdruck können je nach Prozesstemperatur im Bereich von le-7 mbar bis 1000 mbar liegen. Typischerweise liegen der Selen- bzw. Schwefel-Partialdruck im Bereich von etwa 0,001 mbar bis etwa 100 mbar.

Gemäß einer speziellen Ausführungsform des erfindungsgemäßen Verfahrens, welche sich besonders gut zur Herstellung einer I-III-VI-Verbindungs-Halbleiterschicht bzw. Chalcopyrit-Halbleiterschicht eignet, umfasst das Verfahren die Schritte:
- Erhöhen der Substrattemperatur mit einer Aufheizrate von etwa 5°C/min bis 600°C/min, bevorzugt 10°C/min bis 60°C/min, von Raumtemperatur auf eine Temperatur im Bereich von etwa 400°C bis 600°C, bevorzugt 400°C bis 500°C;
- Zuführen von elementarem Selendampf in die Prozesskammer ab einer Substrattemperatur zwischen 120°C und 300°C und dabei Nachführen der Selenquellentemperatur auf einen gewünschten Partialdruck, bevorzugt zwischen 0,001 mbar und 100 mbar;
- Halten der Substrattemperatur im Bereich von 400°C bis 600°C für 1 min bis 60 min, bevorzugt für 10 min bis 30 min;
- Abschalten der Zuführung von elementarem Selen- und gegebenenfalls Schwefeldampf in die Prozesskammer nach einer ersten vorbestimmten Zeitdauer;
- mindestens einmaliges Abpumpen und/oder Spülen der Prozesskammer;
- Zuführen von elementarem Schwefeldampf in die Prozesskammer;
- weiteres Erhöhen der Substrattemperatur mit einer Aufheizrate von etwa 5°C/min bis 600°C/min, bevorzugt 10°C/min bis 60°C/min, auf eine Temperatur im Bereich von etwa 450°C bis 650°C, bevorzugt 500°C bis 550°C, und dabei Nachführen der Schwefelquellentemperatur auf einen gewünschten Partialdruck, bevorzugt zwischen 0,001 mbar und 100 mbar;
- Halten der Substrattemperatur im Bereich von 450°C bis 650°C für 1 min bis 60 min, bevorzugt für 10 min bis 30 min;
- Abschalten der Zuführung von elementarem Schwefeldampf in die Prozesskammer nach einer zweiten vorbestimmten Zeitdauer;
- Abkühlen des Substrats; und
- Abpumpen und/oder Spülen der Prozesskammer.

Vorteilhafterweise wird bereits während des Selenisierungsschritts, z.B. ab einer Substrattemperatur von 120°C bis 600°C, elementarer Schwefeldampf in die Prozesskammer zugeführt, insbesondere derart, dass sich ein Partialdruck-Verhältnis von Selen zu Schwefel zwischen 0 und 0,9, bevorzugt zwischen 0,1 und 0,3, einstellt.

Obwohl das erfindungsgemäße Verfahren bislang vor allem im Zusammenhang mit der Selenisierung bzw. Sulphurisierung einer Metallschicht zur Herstellung einer Chalcopyrit-Halbleiterschicht beschrieben wurde, ist darauf hinzuweisen, dass sich das erfindungsgemäße Verfahren auch zur Herstellung anderer Halbleiterschichten eignet. So kann es sich bei der herzustellenden Halbleiterschicht auch um eine Pufferschicht, beispielsweise eine In₂S₃-Schicht, handeln. In diesem Fall würde die Metallschicht Indium umfassen. Konkret könnte beispielsweise auf einer auf Molybdän gebildeten I-III-V-Halbleiterschicht eine dünne Schicht von Indium abgeschieden werden, um eine In₂S₃-Halbleiter-Pufferschicht auf dem I-III-V-Halbleiter zu bilden. Entsprechend ist es aber auch denkbar, dass die Metallschicht Zn oder Mg aufweist, woraus sich dann entsprechend ZnS-oder MgS-Schichten bilden lassen.

Je nach Prozessführung oder herzustellender Halbleiterschicht kann es dabei von Vorteil sein, wenn dem den elementaren Selen- oder Schwefeldampf enthaltenden Trägergas zusätzlich mindestens ein reaktives Gas, wie z.B. Sauerstoff oder Wasserstoff, beigemischt wird.

Weiterer Gegenstand der Erfindung ist außerdem eine Prozessvorrichtung mit den Merkmalen des Anspruchs 11, mittels der sich das voranstehend beschriebene Verfahren besonders gut durchführen lässt.

Die erfindungsgemäße Prozessvorrichtung umfasst eine evakuierbare Prozesskammer zur Aufnahme wenigstens eines zu prozessierenden Substrats und insbesondere eines Stapels von zu prozessierenden Substraten, eine Heizeinrichtung zum konvektiven Erwärmen des zu prozessierenden Substrats, eine außerhalb der Prozesskammer gelegene und durch eine Zuführleitung mit der Prozesskammer verbundene Quelle für elementaren Selen- und/oder Schwefeldampf und eine Temperiereinrichtung, um zumindest einen Teilbereich einer die Prozesskammer definierenden Wand und zumindest einen Abschnitt der Zuführleitung jeweils auf einer vorgegebenen Temperatur zu halten.

Durch die Temperiereinrichtung können die Prozesskammerwand und die Zuführleitung auf einer Temperatur gehalten werden, bei welcher das Material der Prozesskammerwand bzw. der Zuführleitung auch unter Einfluss der Prozessgasatmosphäre nicht korrodiert. Beispielsweise ist es bekannt, dass ein Korrosionsangriff deutlich mit der Temperatur ansteigt und bei Temperaturen im Bereich unter 250°C Edelstahl in einer selen- oder schwefelhaltigen Prozessgasatmosphäre kaum merklich korrodiert. Aufgrund der bekannten Dampfdruckkurven für Selen und Schwefel ist nicht zu erwarten, dass Selen bzw. Schwefel unter den Prozessbedingungen an den temperierten und thermisch isolierten Wänden der Prozesskammer kondensiert. Durch die Temperierung ist die Prozesskammer dem Typus eines Heißwand-Reaktors zuzuordnen, welche langzeitstabil ist und keine prozess-schädigenden Partikel abgibt. Des Weiteren ist durch die Temperierung sichergestellt, dass der Prozess sehr gut kontrollierbar ist, da im allgemeinen dampf- oder gasförmige Bestandteile des Prozessgases und im besonderen Selen oder Schwefel während des Prozessablaufes weder unkontrollierbar herauskondensiert werden noch unkontrollierbar wieder in den Prozess zurückgeführt werden.

Die Prozesskammer kann aus einem Metallmaterial gebildet sein. Hierdurch lässt sich die Prozesskammer nicht nur bei gleicher Prozessierkapazität, sondern vor allem auch bei einem größeren Kammervolumen mit einem geringeren wirtschaftlichen Aufwand als beispielsweise ein Quarzrohr herstellen. Während sich Quarzrohr-Diffusionsöfen nur mit einem Durchmesser von bis zu 80 cm fertigen lassen, kann eine aus einem Metallmaterial gebildete Prozesskammer durch eine entsprechende Erhöhung und Verbreiterung vergleichsweise leicht an größere Prozessgutformate, d.h. Substratflächen, angepasst werden.

Vorteilhafterweise ist an der Innenseite der Prozesskammerwand ein thermisches Isolationsmaterial vorgesehen, das unter Prozessbedingungen vorzugsweise reaktionsbeständig ist. Das Isolationsmaterial bildet zum einen zusätzlichen Schutz der Prozesskammerwand, z.B. vor Korrosion, und schafft zum anderen eine gewisse thermische Entkopplung der Prozesskammerwand von der in der Prozesskammer befindlichen Gasatmosphäre, sodass sich die Temperatur der Gasatmosphäre genauer steuern lässt. Die thermische Entkopplung beruht im Wesentlichen auf der geringen spezifischen Wärmekapazität, der geringen thermischen Leitfähigkeit und der in einigen Fällen geringen Emissivität, wie sie typisch für Isolationsmaterialien ist. Außerdem verhindert das thermische Isolationsmaterial, dass die Prozesskammerwand durch heißes Prozessgas über die vorgegebene Temperatur hinaus erwärmt wird oder der Wärmeaustrag zu groß wird. Das Thermische Isolationsmaterial ist insbesondere bei erzwungener Konvektion durch die Gasfördereinrichtung vorteilhaft, weil so der Wärmeaustrag aufgrund eines ansonsten guten Wärmeübergangs deutlich eingedämmt wird.

Bei dem Isolationsmaterial kann es sich beispielsweise um eine Keramik, eine Glaskeramik, Graphit, einschließlich eines Faserstoffes, wie z.B. Carbon Fiber Inforced Carbon (CFC), oder einen keramikfaserhaltigen Isolationsstoff, z.B. bestehend aus SiO₂- und Al₂O₃-Fase handeln.

Gemäß einer Ausführungsform der Prozessvorrichtung umfasst die Quelle eine beheizbare und evakuierbare Quellenkammer, in der ein mit Selen-oder Schwefelschmelze gefüllter Tiegel angeordnet ist, und eine Leitung für, insbesondere vorgewärmtes, Trägergas derart, dass das Trägergas entweder nach dem Prinzip eines Bubblers durch die Selen- oder Schwefelschmelze hindurchgeleitet wird oder über eine Oberfläche der Selen-oder Schwefelschmelze hinweggeleitet wird. Der beheizbare Tiegel und die beheizbare Leitung weisen bevorzugt ein in Selen oder Schwefel reaktionsbeständiges Material auf und sind z.B. aus Keramik, Quarz oder korrosionsbeständigen Speziallegierungen gebildet.

Gemäß einer weiteren Ausführungsform ist eine Gasfördereinrichtung zum Erzeugen eines Gasströmungskreislaufs in der Prozesskammer vorgesehen, wobei die Gasfördereinrichtung bevorzugt wenigstens einen Ventilator umfasst. Der Ventilator kann beispielsweise als Axial- oder Radial-Lüfter ausgeführt sein.

Der Ventilator kann ein reaktionsbeständiges Material aufweisen und an einer Antriebswelle befestigt sein, die in die Prozesskammer hineinreicht und die vorzugsweise ebenfalls ein reaktionsbeständiges Material aufweist. Durch die Verwendung des reaktionsbeständigen Materials sind auch der Ventilator und/oder die Antriebswelle vor einem Angriff durch reaktive Bestandteile des Prozessgases und insbesondere vor Korrosion geschützt.

Vorteilhafterweise ist der Ventilator im Bereich einer der Stirnseiten des Substratstapels angeordnet. Diese Anordnung des Ventilators trägt zu einer besonders homogenen Durchströmung eines Substratstapels mit Prozessgas und somit zu einer besonders homogenen Schichtabscheidung und Schichtreaktion bei.

Um die Strömungsgeschwindigkeit und die Homogenität der Gasströmung noch weiter zu erhöhen, ist vorteilhafterweise ein weiterer Ventilator im Bereich der anderen Stirnseite des Substratstapels angeordnet. Bei dieser Anordnung von zwei Ventilatoren ist vorzugsweise der eine Ventilator so ausgebildet, dass er das Prozessgas in den Substratstapel hineinfördert, während der andere Ventilator das Prozessgas aus dem Substratstapel hinausfördert. Der eine Ventilator arbeitet mit anderen Worten im sogenannten Schub-Betrieb, während der andere im Saug-Betrieb arbeitet.

Bei dem reaktionsbeständigen Material des Ventilators bzw. der Antriebswelle kann es sich beispielsweise um ein Keramikmaterial, wie z.B. Siliziumnitrid oder Siliziumkarbid, handeln.

Vorzugsweise lässt sich der Antrieb des Ventilators bzw. lassen sich die Antriebe der Ventilatoren auch in umgekehrter Drehrichtung betreiben, sodass der Gasströmungskreislauf umgekehrt werden kann. Wahlweise können Radial-Ventilatoren an beiden Seiten des Substratstapels angebracht sein, bei denen die Umkehrung der Gasströmungsrichtung durch Einschalten des vorher ausgeschalteten Ventilators und Ausschalten des vorher eingeschalteten Ventilators erfolgt.

Erfindungsgemäß ist die Heizeinrichtung in dem von der Gasfördereinrichtung erzeugten Gasströmungskreislauf angeordnet, um ein in der Prozesskammer befindliches Gas aufzuheizen, insbesondere das mit dem elementaren Selen- bzw. Schwefeldampf versetzte Trägergas. Die Heizeinrichtung ist mit anderen Worten innerhalb der Prozesskammer angeordnet, sodass auf eine außerhalb der Prozesskammer liegende Wärmequelle, z.B. Infrarotstrahlungsquelle, zur Erwärmung des Prozessgases verzichtet werden kann. Die Prozesskammer braucht somit nicht hinsichtlich Infraroteinstrahlung optimiert zu werden, was die Konstruktion der Prozesskammer erheblich vereinfacht und außerdem ebenfalls die Verwendung eines Metallmaterials zur Herstellung der Prozesskammer ermöglicht.

Die Heizeinrichtung kann wenigstens ein korrosionsbeständiges Heizelement umfassen. Insbesondere kann die Heizeinrichtung als Plattenstapel von Widerstands-Heizelementen ausgeführt sein. Beispielsweise können hierbei Graphit- oder Siliziumkarbid-Heizelemente als plattenförmige Mäanderheizer oder als Heizstäbe zum Einsatz kommen. In Abhängigkeit von der Auslegung der Gasströmungsgeschwindigkeit, der Heizerleistung und der Oberfläche der Heizermatrix können Aufheizraten der Prozessgüter von einigen Grad Celsius pro Minute bis zu einigen Grad Celsius pro Sekunde erreicht werden.

Gemäß noch einer weiteren Ausführungsform ist eine Kühleinrichtung zum Abkühlen eines in der Prozesskammer befindlichen Gases, insbeson-dere des mit dem elementaren Selen- bzw. Schwefeldampf versetzten Trägergases, in dem von der Gasfördereinrichtung erzeugten Gasströmungskreislauf angeordnet.

Die Kühleinrichtung kann wenigstens ein Kühlelement und insbesondere einen Plattenstapelkühler oder einen Rohrbündelkühler umfassen. Das Kühlelement kann beispielsweise mittels eines Öltemperiergeräts auf einer Temperatur von z.B. etwa 200°C gehalten werden. In Abhängigkeit von der Gasströmungsgeschwindigkeit, der Kühlerleistung und der Oberfläche der Kühleranordnung können Abkühlraten von bis zu einigen Grad Celsius pro Minute auf den Prozessgütern erreicht werden.

Gemäß noch einer weiteren Ausführungsform sind Gasumlenkelemente vorgesehen, durch die der Gasströmungskreislauf derart umlenkbar ist, dass entweder die Heizeinrichtung oder eine Kühleinrichtung in dem Gasströmungskreislauf angeordnet ist. Die Gasumlenkelemente ermöglichen bei entsprechender Einstellung eine besonders schnelle Erwärmung bzw. Abkühlung der Prozessgüter auf eine gewünschte Temperatur und dadurch letztlich die Realisierung nahezu beliebiger Temperaturprofile in der Prozesskammer.

Zusätzlich zu der Gasfördereinrichtung kann die Prozessvorrichtung eine Gasleiteinrichtung aufweisen, die einen Substratstapel aufnimmt und die in der Prozesskammer derart angeordnet ist, dass mindestens ein Teil des erzeugten Gasströmungskreislaufes durch die Gasleiteinrichtung hindurch verläuft. Die Gasfördereinrichtung und die Gasleiteinrichtung sorgen einerseits für ein besonders homogenes Aufheizen und Abkühlen des Substratstapels durch erzwungene Konvektion und andererseits für eine besonders homogene Gasverteilung und dadurch letztlich besonders homogene Schichtbildung, z.B. eines Chalcopyrit-Halbleiters, auf den Substraten.

Die Kombination von Gasfördereinrichtung, Gasleiteinrichtung und Heizeinrichtung ermöglicht eine erhöhte Aufheiz- und Abkühlgeschwindigkeit, wodurch kürzere Prozesszeiten und somit ein höherer Durchsatz von Prozessgütern möglich sind.

Die Gasleiteinrichtung kann mindestens eine obere Trennplatte, die einen ersten Kammerbereich in der Prozesskammer oberhalb der den Substratstapel aufnehmenden Gasleiteinrichtung definiert, und eine untere Trennplatte aufweisen, die einen zweiten Kammerbereich in der Prozesskammer unterhalb der den Substratstapel aufnehmenden Gasleiteinrichtung definiert. Zusätzlich kann die Gasleiteinrichtung auch zwei seitliche Trennplatten aufweisen.

Bevorzugt weist die Gasleiteinrichtung zumindest eine Verteilervorrichtung zur flächig gleichmäßigen Verteilung der Gasströmung auf, wobei der Substratstapel vorzugsweise stromabwärts von der Verteilervorrichtung angeordnet ist. Bei der Verteilervorrichtung kann es sich beispielsweise um eine Platte handeln, die mit Schlitzen und/oder Löchern versehen ist. Die Verteilervorrichtung und die Gasleiteinrichtung bestehen vorzugsweise aus einem reaktionsbeständigen Material, wie z.B. aus einer Glaskeramik, Siliziumkarbid, Quarz oder Siliziumnitrid.

Ähnlich wie die Prozesskammerwand können auch die Oberflächen der Gasleiteinrichtung mit einem thermischen Isolationsmaterial versehen sein, welches unter Prozessbedingungen vorzugsweise reaktionsbeständig ist. Auf diese Weise ist auch die Gasleiteinrichtung zumindest weitgehend von der Gasatmosphäre in der Prozesskammer thermisch entkoppelt, sodass die Prozessvorrichtung, insbesondere im dynamischen Fall einer Temperatur-Solländerung, insgesamt eine geringere thermische Masse aufweist, wodurch sich die Temperatur des Prozessgases in der Prozesskammer noch schneller und genauer steuern lässt. Durch seine Reaktionsbeständigkeit gegenüber reaktiven Bestandteilen des Prozessgases bildet das Isolationsmaterial außerdem einen zusätzlichen Schutz für die Gasleiteinrichtung, z.B. vor Korrosion.

Weiterer Gegenstand der Erfindung ist ferner eine Prozessanlage zum Prozessieren von gestapelten Prozessgütern mit wenigstens einer Prozessvorrichtung der voranstehend beschriebenen Art, wobei die Prozessvorrichtung eine Beladungsöffnung, durch die der Prozessgutstapel in die Gasleiteinrichtung einbringbar ist, und eine Entladungsöffnung aufweist, durch die der Prozessgutstapel aus der Gasleiteinrichtung entnehmbar ist.

Vorteilhafterweise umfasst die Prozessanlage eine weitere Prozessvorrichtung, die relativ zu der einen Prozessvorrichtung benachbart angeordnet ist und eine Beladungsöffnung aufweist, welche mit der Entladungsöffnung der einen Prozessvorrichtung ausgerichtet ist. Die Beladungsöffnung und/oder Entladungsöffnung können bzw. kann dabei durch eine Tür, insbesondere ein Plattenventil, verschließbar sein.

Bevorzugt ist die weitere Prozessvorrichtung eine Abkühlvorrichtung, die eine Kühleinrichtung aufweist, welche in einem Gasströmungskreislauf angeordnet ist, der in einer evakuierbaren Prozesskammer der Abkühlvorrichtung durch eine Gasfördereinrichtung erzeugt wird. Außerdem kann die Prozessanlage eine der in Durchlaufrichtung gesehen ersten Prozessvorrichtung vorgelagerte Einschleuskammer umfassen.

Durch die benachbarte Anordnung mehrerer Prozessvorrichtungen bildet die Prozessanlage eine Durchlaufanlage für den zu prozessierenden Prozessgutstapel. Es handelt sich gewissermaßen also um eine "Batch-Inline-Anlage", welche die Vorteile eines kontinuierlichen Durchlaufbetriebs mit denen eines Batch-Betriebs in sich vereint.

Es versteht sich von selbst, dass die Anzahl der Prozessvorrichtungen nicht auf zwei beschränkt ist. Vielmehr kann die Prozessanlage beispielsweise eine Anzahl n von Prozessvorrichtungen und eine Anzahl m von Abkühlvorrichtungen umfassen, wobei n und m natürliche Zahlen sind und wobei lediglich für die einfachste Variante einer Batch-Inline-Kombinations-Prozessanlage n = m = 1 gilt.

Nachfolgend wird die Erfindung anhand einer vorteilhaften Ausführungsform rein beispielhaft und unter Bezugnahme auf die beigefügte Zeichnung beschrieben. Es zeigen:
- Fig. 1: eine schematische Darstellung einer erfindungsgemäßen Prozessvorrichtung;
- Fig. 2: Dampfdruckkurven von Selen und Schwefel als Funk-tion der Quellentemperatur;
- Fig. 3: den zeitlichen Verlauf von Substrattemperatur und Quellentemperatur während eines in der Vorrichtung von Fig. 1 durchgeführten Verfahrens zur Herstellung eines Chalcopyrit-Halbleiters;
- Fig. 4: eine schematische Längsschnittansicht der Prozessvorrichtung entlang der Linie A-A von Fig. 1;
- Fig. 5: eine schematische Längsschnittansicht einer Prozessanlage mit einer Prozessvorrichtung der in Fig. 1 gezeigten Art und einer daneben angeordneten Abkühlvorrichtung; und
- Fig. 6: eine schematische Längsschnittansicht einer alternativen Ausführungsform einer Prozessanlage mit einer der Prozessvorrichtung vorgelagerten Einschleuskammer und einer der Prozessvorrichtung nachgelagerten Abkühlvorrichtung.

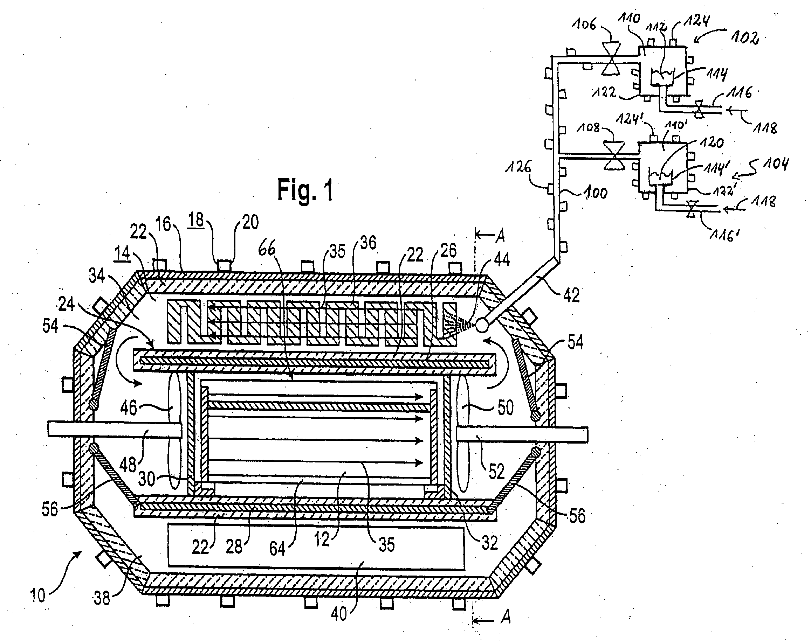

In Fig. 1 ist eine erfindungsgemäße Prozessvorrichtung 10 dargestellt, die zum Ausbilden von Cu(In, Ga)(Se, S)₂-Halbleiterdünnschichten auf Substraten 12 vorgesehen ist, welche zur Herstellung von Solarzellen verwendet werden sollen.

Die Prozessvorrichtung 10 umfasst eine evakuierbare Prozesskammer 14, die durch eine Prozesskammerwand 16 begrenzt ist. Die Prozesskammerwand 16 ist aus Edelstahl gebildet und wird durch eine Temperiereinrichtung 18 auf einer Temperatur im Bereich von 150°C bis 250°C gehalten.

Im vorliegenden Ausführungsbeispiel ist die Temperiereinrichtung 18 durch an der Außenseite der Prozesskammer 14 angebrachte, insbesondere an der Prozesskammerwand 16 angeschweißte, die Prozesskammer 14 mäanderförmig umlaufende Rohrleitungen 20 gebildet, durch welche ein geeignetes Heißöl strömt. Alternativ oder zusätzlich kann das Heißöl aber auch durch in die Prozesskammerwand 16 entsprechend eingelassene Kanäle (nicht gezeigt) strömen. Zusätzlich kann die Außenseite der Prozesskammerwand 16 mit einem thermischen Isolationsmaterial versehen sein.

An einer Innenseite der Prozesskammerwand 16 ist die Prozesskammer 14 zumindest annähernd vollständig mit einem korrosionsfesten partikelarmen thermischen Isolationsmaterial 22 ausgekleidet. Bei dem thermischen Isolationsmaterial 22 kann es sich um eine Keramik, eine Glaskeramik, um Graphit, einschließlich eines Faserstoffes, wie z.B. Carbon Fiber Inforced Carbon (CFC), oder um einen keramikfaserhaltigen Isolationsstoff, der z.B. aus SiO₂- und Al₂O₃-Fasern besteht, handeln.

In einem mittleren Bereich der Prozesskammer 14 ist eine Gasleiteinrichtung 24 angeordnet. Die Gasleiteinrichtung 24 umfasst eine obere Trennplatte 26 und eine untere Trennplatte 28. Zusätzlich zu der oberen und unteren Trennplatte 26, 28 können eine vordere und eine hintere Trennplatte (nicht gezeigt) vorgesehen sein. Üblicherweise fehlen aber die vordere und hintere Trennplatte, da deren Funktion durch die thermisch isolierten Kammerseitenwände einschließlich dort angeordneter Türen oder Vakuumventile erfüllt werden.

Die obere und untere Trennplatte 26, 28 sowie gegebenenfalls auch die vordere und hintere Trennplatte sind vorzugsweise aus einem korrosionsfesten Material gebildet, wie beispielsweise einem Keramikmaterial, wie z.B. Siliziumkarbid oder Siliziumnitrid, oder einem Glaskeramikmaterial. Außerdem sind alle Trennplatten jeweils mit einer Schicht des bereits genannten thermischen Isolationsmaterials 22 verkleidet.

Die Gasleiteinrichtung 24 umfasst ferner eine erste Verteilereinrichtung 30, die im Bereich einer ersten (in Fig. 1 linken) Stirnseite der Gasleiteinrichtung 24 zwischen den Trennplatten 26, 28 angeordnet ist, und eine zweite Verteilereinrichtung 32, die im Bereich einer zweiten (in Fig. 1 rechten) Stirnseite der Gasleiteinrichtung 24 zwischen den Trennplatten 26, 28 angeordnet ist. Die Verteilereinrichtungen 30, 32 sind jeweils aus einem korrosionsfesten Material, wie z.B. Siliziumkarbid, Siliziumnitrid oder einem Glaskeramikmaterial, gebildet. Bei den Verteilereinrichtungen 30, 32 handelt es sich im vorliegenden Ausführungsbeispiel jeweils um eine Platte, die mit einer Vielzahl von vertikal und insbesondere mit den Substraten 12 ausgerichteten Schlitzen 33 versehen ist. Alternativ oder zusätzlich kann in der oder jeder Platte auch eine Vielzahl von Löchern ausgebildet sein.

Die obere und untere Trennplatte 26, 28, die erste und zweite Verteilereinrichtung 30, 32 und gegebenenfalls auch die nicht gezeigte vordere und hintere Trennplatte bilden eine Einhausung für die Substrate 12, die zumindest annähernd spaltdicht ausgeführt ist, damit ein durch die Gasleiteinrichtung 24 strömender Gasstrom 35 in der Einhausung geführt wird und nicht seitlich aus dieser entweichen kann.

In einem zwischen der oberen Trennplatte 26 und der Prozesskammerwand 16 gelegenen oberen Kammerbereich 34 ist eine Heizeinrichtung 36 angeordnet, beispielsweise eine Siliziumkarbid-Mäander-Heizermatrix, während in einem zwischen der unteren Trennplatte 28 und der Prozesskammerwand 16 gelegenen unteren Kammerbereich 38 eine Kühleinrichtung 40, beispielsweise ein Plattenstapelkühler, angeordnet ist. Alternativ kann die Kühleinrichtung 40 in dem oberen Kammerbereich 34 und die Heizeinrichtung 36 in dem unteren Kammerbereich 38 angeordnet sein, oder können die Heiz- und Kühleinrichtung übereinander im oberen oder unteren Kammerbereich angeordnet sein (nicht gezeigt). In letzterem Falle sind lediglich eine Trennplatte und ein Paar von Gasumlenkelementen nötig. Die Trennplatte ist dann zwischen der Heiz- und Kühleinrichtung angeordnet, und die Gasumlenkelemente sind an den Stirnseiten der Trennplatte angeordnet.

Im Bereich eines Endes (in Fig. 1 des rechten Endes) der Heizeinrichtung 36 ist eine Gaseinlasseinrichtung 42 angeordnet, die sich durch die Prozesskammerwand 16 erstreckt und es ermöglicht, der Prozesskammer 14 von außen ein Prozessgas 44 zuzuführen, im vorliegenden Ausführungsbeispiel ein elementaren Selen- oder Schwefeldampf aufweisendes Gas. Obwohl die Gaseinlasseinrichtung 42 grundsätzlich an einer beliebigen Stelle der Prozesskammer 14 angeordnet sein kann, ist die in Fig. 1 gezeigte Anordnung besonders vorteilhaft, da das durch die Gaseinlasseinrichtung 42 zugeführte Prozessgas 44 bei Normalbetrieb zunächst die Heizeinrichtung 36 durchläuft und somit unmittelbar nach dem Eintreten in die Prozesskammer 14 erwärmt wird.

Die Gaseinlasseinrichtung 42 ist durch eine Zuführleitung 100 mit einer Quelle 102 für elementaren Selendampf und mit einer Quelle 104 für elementaren Schwefeldampf verbunden. Der Quelle 102 für elementaren Selendampf und der Quelle 104 für elementaren Schwefeldampf ist jeweils ein in der Zuführleitung 100 angeordnetes Ventil 106 bzw. 108 zugeordnet, welches es ermöglicht, die Quelle 102 für elementaren Selendampf bzw. die Quelle 104 für elementaren Schwefeldampf selektiv zuzuschalten und somit der Prozesskammer 14 wahlweise elementaren Selendampf und/oder elementaren Schwefeldampf zuzuführen.

Die Quelle 102 für elementaren Selendampf umfasst eine evakuierbare Quellenkammer 110, in der ein mit Selenschmelze 112 gefüllter Tiegel 114 angeordnet ist. Des Weiteren umfasst die Quelle 102 eine Leitung 116 für ein vorgeheiztes inertes Trägergas 118, beispielsweise Stickstoff oder Argon. Die Vorheizung kann so geregelt werden, dass die Trägergastemperatur die Tiegeltemperatur nicht unterschreitet.

Im dargestellten Ausführungsbeispiel ist die Leitung 116 derart angeordnet, dass das Trägergas 118 nach dem Prinzip eines Bubblers durch die Selenschmelze 112 hindurchgeleitet wird. Alternativ wäre es aber auch möglich, die Leitung 116 so anzuordnen, dass das Trägergas über die Oberfläche der Selenschmelze 112 hinweggeleitet wird. Letztlich kommt es bei der Konfiguration der Quelle 102 vor allem darauf an, dass das Trägergas derart durch die Quelle 102 hindurchgeführt wird, dass es den aus der Selenschmelze 112 verdampfenden elementaren Selendampf in die Prozesskammer 14 transportiert.

Um eine ausreichende Verdampfung des elementaren Selens aus der Selenschmelze 112, d.h. also einen ausreichenden Dampfdruck, sicherzustellen, wird die Selenschmelze 112 mittels einer nicht dargestellten Heizeinrichtung auf einer vorgegebenen Selen-Quellentemperatur gehalten. Alternativ kann ein Temperaturprofil der Quelle gefahren werden, das den für den Prozess erforderlichen Selen-Partialdruckverlauf ermöglicht.

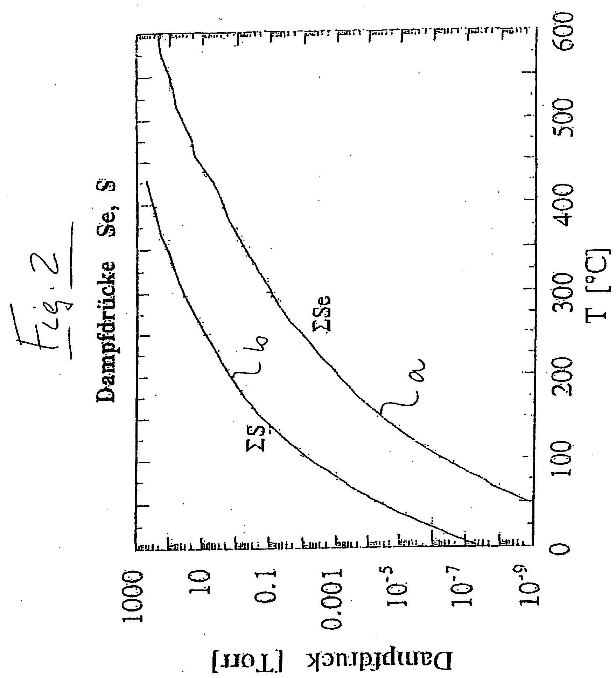

Wie der in Fig. 2 gezeigten Selen-Dampfdrucckurve zu entnehmen ist (Kurve a), werden signifikante Dampfdrücke von größer als 1 Torr (1 Torr = 1,3 mbar) erst bei einer Selen-Quellentemperatur ab etwa 360°C erreicht. Der Selenisierungsprozess kann jedoch wie nachfolgend näher erläutert unter Grobvakuum-, Umgebungsdruck- oder Überdruckbedingungen durchgeführt werden, z.B. bei einem Prozesskammerdruck oder Totaldruck von mindestens 900 mbar.

Bei dem dargestellten Ausführungsbeispiel wird der erforderliche Prozesskammerdruck überwiegend durch den Druck des Trägergases 118 eingestellt, welches den Selendampf mit einem Totaldruck als Summe aus Trägergasdruck und Selendampfdruck entsprechend der Quellentemperatur in die Prozesskammer 14 transportiert. Beispielsweise kann bei einem Totaldruck von 900 mbar der Selenpartialdruck auf ca. 30 mbar (1 mbar = 0,7501 Torr) eingestellt werden, indem die Selen-Tiegeltemperatur auf ca. 450°C eingestellt wird, das Trägergas auf mindestens 450°C eingestellt wird und die Temperatur auf den inneren Oberflächen der Prozesskammer 14 und insbesondere auf den Substraten 12 an keinem Punkt 450°C unterschreitet, um Auskondensation von Selen zu vermeiden. Die für einen reproduzierbaren und sehr gut kontrollierbaren Prozess wesentliche Bedingung der Vermeidung einer Auskondensation der Prozessdämpfe kann mit der erfindungsgemäßen Kammeranordnung unter Verwendung der erzwungenen Konvektion besonders erfolgreich verwirklicht werden.

Die Quelle 104 für elementaren Schwefeldampf weist einen der Quelle 102 entsprechenden Aufbau auf, d.h. auch die Quelle 104 umfasst eine evakuierbare Quellenkammer 110', in der ein Tiegel 114' angeordnet ist, der in diesem Fall jedoch eine Schwefelschmelze 120 enthält. Im vorliegenden Ausführungsbeispiel umfasst auch die Quelle 104 eine Leitung 116', um vorgeheiztes Trägergas 118, z.B. Stickstoff, durch die Schwefelschmelze 120 hindurchzuleiten. Wie bei der Quelle 102 kann die Leitung 116' der Quelle 104 aber auch so angeordnet sein, dass das Trägergas über eine Oberfläche der Schwefelschmelze 120 hinweggeleitet wird.

Ferner wird auch die Schwefelschmelze 120 der Quelle 104 mittels einer nicht dargestellten Heizeinrichtung auf einer vorgegebenen Quellentemperatur gehalten, um eine ausreichende Verdampfung von elementarem Schwefeldampf bzw. einen ausreichenden Dampfdruck sicherzustellen. Alternativ kann auch hier ein Temperaturprofil der Quelle gefahren werden, das den für den Prozess erforderlichen Schwefel-Partialdruckverlauf ermöglicht.

Wie der in Fig. 2 gezeigten Schwefel-Dampfdruckkurve zu entnehmen ist (Kurve b), wird - anders bei Selen - ein Dampfdruck von 30 mbar im Falle von Schwefel bereits bei einer Schwefel-Quellentemperatur ab etwa 280°C erreicht.

Ähnlich wie bei der Quelle 102 für elementaren Selendampf wird aber auch bei der Quelle 104 für elementaren Schwefeldampf gemäß dem dargestellten Ausführungsbeispiel der erforderliche Prozesskammerdruck überwiegend durch den Druck des Trägergases 118 eingestellt, welches den Schwefeldampf mit einem Totaldruck als Summe aus Trägergasdruck und Schwefeldampfdruck entsprechend der Quellentemperatur in die Prozesskammer 14 transportiert.

Um zu verhindern, dass der elementare Selen- bzw. Schwefeldampf an den Wänden 122, 122' der Quellenkammern 110, 110' oder an der Wand der Zuführleitung 100 kondensiert, werden die Quellenkammerwände 122, 122' und die Zuführleitung 100 jeweils mittels einer Temperiereinrichtung 124, 124', 126 auf einer vorgegebenen Temperatur gehalten. Dabei sollten die Temperaturen der Gaseinlasseinrichtung 42, der Zuführleitung 100 und der Quellenkammerwand 122 mindestens so hoch sein wie die des Tiegels 114 für elementaren Selendampf und die Temperaturen der Zuführleitung 100 und der Quellenkammerwand 122' mindestens so hoch sein wie die des Tiegels 114' für elementaren Schwefeldampf.

Außerdem weisen der Tiegel 114, die Quellenkammerwand 122, das Ventil 106 und die Leitung 116 der Quelle 102 ein in Selen reaktionsbeständiges Material auf, während der Tiegel 114', die Quellenkammerwand 122', das Ventil 108 und die Leitung 116' der Quelle 104 ein in Schwefel reaktionsbeständiges Material aufweist. Entsprechend sind auch die Zuführleitung 100 und die Gaseinlasseinrichtung 42 aus einem in Selen und Schwefel reaktionsbeständigen Material gebildet. Bei den reaktionsbeständigen Materialien kann es sich beispielsweise um eine Keramik, Quarz, eine korrosionsbeständige Speziallegierung oder ein mit einer korrosionsfesten Schicht überzogenes Metall oder Metalllegierung handeln. Die Selen- und Schwefelquelle sowie die Zu- und Ableitungen werden mit thermisch isolierten gasdichten Einhausungen (nicht gezeigt) versehen, die im Falle eines Bruches der korrosionsfesten Materialen einen Austritt von Selen und Schwefel in die Umgebung verhindern. Der Zwischenraum zwischen Einhausung und jenen korrosionsfesten Materialien kann z.B. mit Stickstoff beaufschlagt werden, um einen Lufteinbruch in die Prozesskammer zu verhindern. Zur Überwachung einer möglichen Leckage an der Selen- bzw. Schwefelquelle kann die Stickstoff-Beaufschlagung drucküberwacht sein.

Wie Fig. 1 zeigt, ist im Bereich der ersten Stirnseite der Gasleiteinrichtung 24 wenigstens ein erster Ventilator 46 der ersten Verteilereinrichtung 30 vorgelagert, welcher durch eine sich durch die Prozesskammerwand 16 erstreckende erste Antriebswelle 48 angetrieben wird. Auf der gegenüberliegenden Seite der Gasleiteinrichtung 24 sind zwei zweite Ventilatoren 50 im Bereich der zweiten Verteilereinrichtung 32 angeordnet, welche durch sich durch die Prozesskammerwand 16 erstreckende zweite Antriebswellen 52 angetrieben werden. Die Anordnung kann aber auch mit Ventilatoren nur auf einer Seite ausgeführt werden, z.B. mit Ventilatoren 50.

Sowohl die ersten und zweiten Ventilatoren 46, 50 als auch die ersten und zweiten Antriebswellen 48, 52 sind aus einem korrosionsbeständigen Material, wie z.B. einem Keramikmaterial, insbesondere Siliziumnitrid oder Siliziumkarbid oder einem mit einer korrosionsfesten Beschichtung überzogenen Material wie Metall oder Metalllegierung, gebildet. Die ersten Ventilatoren 46 werden so angetrieben, dass sie Gas in die Gasleiteinrichtung 24 hineinfördern, während die zweiten Ventilatoren 50 gleichzeitig so betrieben werden, dass sie Gas aus der Gasleiteinrichtung 24 hinausfördern. Durch den Betrieb der Ventilatoren 46, 50 wird somit ein Gasströmungskreislauf erzeugt, der in der in Fig. 1 gezeigten Ansicht entgegen dem Uhrzeigersinn orientiert ist. D.h. das durch die Gaseinlasseinrichtung 42 in die Prozesskammer 14 eingeleitete Prozessgas 44 strömt von rechts nach links durch die Heizeinrichtung 36, dann nach unten und von links nach rechts durch die Gasleiteinrichtung 24 und anschließend nach oben und erneut von rechts nach links durch die Heizeinrichtung 36.

Zur zusätzlichen Steuerung der Gasströmung in der Prozesskammer 14 sind ein oberes Paar von umschaltbaren Gasumlenkelementen 54 und ein unteres Paar von umschaltbaren Gasumlenkelementen 56 vorgesehen. Die oberen Gasumlenkelemente 54 sind so angeordnet, dass sie die Strömung des Prozessgases 44 aus der Gasleiteinrichtung 24 in den oberen Kammerbereich 34 bzw. aus dem oberen Kammerbereich 34 in die Gasleiteinrichtung 24 zulassen, drosseln oder vollständig verhindern können. Entsprechend sind die unteren Gasumlenkelemente 56 so angeordnet, dass sie eine Strömung des Prozessgases 44 aus der Gasleiteinrichtung 24 in den unteren Kammerbereich 38 bzw. aus dem unteren Kammerbereich 38 in die Gasleiteinrichtung 24 zulassen, drosseln oder vollständig verhindern können.

In der in Fig. 1 dargestellten Situation befinden sich die oberen Gasumlenkelemente 54 in einer offenen Stellung, sodass eine Zirkulation des Prozessgases durch den oberen Bereich der Prozesskammer 14, d.h. durch die Gasleiteinrichtung 24 und die Heizeinrichtung 36 möglich ist.

Die unteren Gasumlenkelemente 56 befinden sich hingegen in einer geschlossenen Stellung, das heißt sie verhindern eine Zirkulation des Prozessgases 44 durch den unteren Bereich der Prozesskammer 14 und insbesondere durch die Kühleinrichtung 40. In der in Fig. 1 dargestellten Situation zirkuliert also ausschließlich heißes Prozessgas, was zur Einhaltung einer gewünschten Prozesstemperatur, beispielsweise im Bereich von 400°C bis 600°C, beiträgt. Werden die oberen Gasumlenkelemente 54 dagegen geschlossen und die unteren Gasumlenkelemente 56 geöffnet, so durchströmt das Prozessgas 44 die Kühleinrichtung 40, und die Substrate 12 werden auf eine reduzierte Temperatur, z.B. 250°C, abgekühlt.

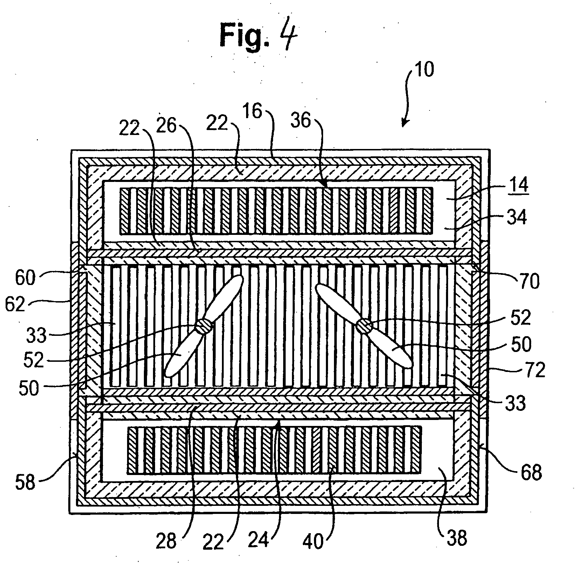

Zur Beladung der Prozesskammer 14 weist die Prozessvorrichtung 10 an seiner Vorderseite eine in die Prozesskammerwand 16 eingelassene Beladungsöffnung 60 auf, die durch ein Plattenventil 62 oder eine andere geeignete Tür verschließbar ist (Fig. 4).

Die zu prozessierenden Substrate 12 werden in einem Träger 64, z.B. einem auf Rollen gelagerten Wagen, vertikal orientiert und zueinander beabstandet angeordnet, um einen Substratstapel 66, auch Batch genannt, zu bilden. Der Substratstapel 66 wird durch die Beladungsöffnung 60 in die Prozesskammer 14 hinein gefahren und in der Gasleiteinrichtung 24 untergebracht. Nach dem Verschließen der Beladungsöffnung 60 erfolgt ein wiederholtes Evakuieren und Spülen der Prozesskammer 14, um den Sauerstoff und Wassergehalt in der Prozesskammer 14 soweit wie möglich zu reduzieren.

Zur Evakuierung der Prozesskammer 14 ist die Prozesskammerwand 16 mit einer geeigneten Absaugöffnung (nicht gezeigt) versehen, an welche eine ebenfalls nicht gezeigte Pumpenanlage angeschlossen ist. Zum Spülen der Prozesskammer 14 ist ein geeigneter Gaseinlass in der Prozesskammerwand 16 vorgesehen, durch den ein Spülgas, wie z.B. N₂, in die Prozesskammer 14 eingeleitet werden kann.

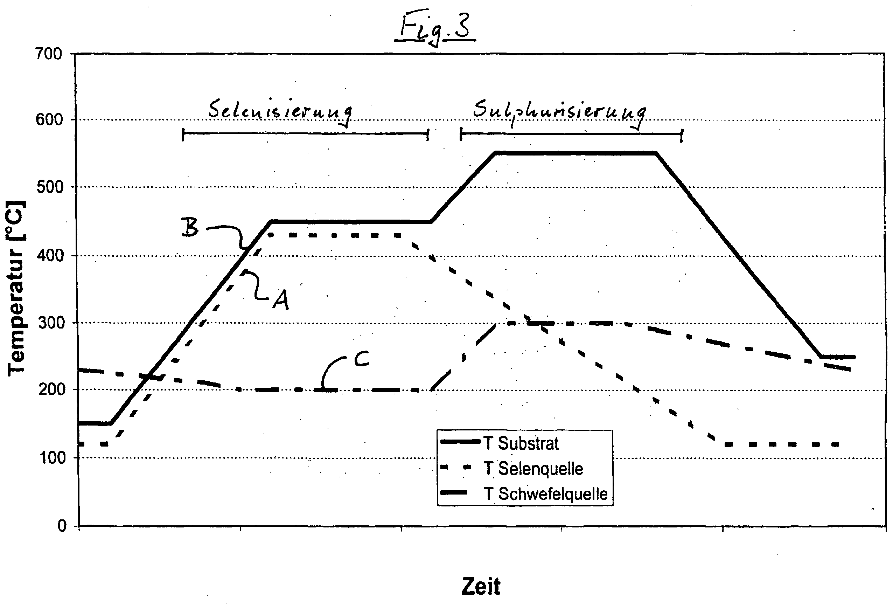

Sobald die Atmosphäre in der Prozesskammer 14 einen geeigneten definierten Ausgangszustand aufweist, werden die Ventilatoren 46, 50 eingeschaltet, die Heizeinrichtung 36 aktiviert und Stickstoffgas in die Prozesskammer 14 eingelassen. Die oberen Gasumlenkelemente 54 sind zu diesem Zeitpunkt geöffnet und die unteren Gasumlenkelemente 56 geschlossen, wie es in Fig. 1 dargestellt ist, um eine Erwärmung der Substrate 12 zu ermöglichen. Gleichzeitig wird die Selen-Quelle auf einer Grundtemperatur von z.B. 150°C bis 300°C gehalten (Kurve A in Fig. 3).

Sobald die Temperatur in der Prozesskammer 14 die erforderliche Reaktionsstarttemperatur, z.B. zwischen Raumtemperatur und 400°C und vorzugsweise zwischen 150°C und 300°C, erreicht hat, wird das der Quelle 102 für elementaren Selendampf zugeordnete Ventil 106 geöffnet und der mit dem Trägergas 118 vermischte elementare Selendampf als Prozessgas 44 durch die Gaseinlasseinrichtung 42 in die Prozesskammer 14 eingeleitet. Dabei wird die Bedingung eingehalten, dass eine Selenkondensation auf den Substraten vermieden wird. Dies wird dadurch erreicht, dass der Selen-Partialdruck in der Prozesskammer den Selen-Dampfdruck entsprechend des Dampfdruckwertes bei der aktuellen Substrattemperatur nicht überschreitet. Durch die Messung des Trägergasdrucks und der Trägergastemperatur in der Prozesskammer vor dem Einlassen des Selendampfes und durch Kenntnis des Prozesskammervolumens sowie durch die Messung der Substrattemperatur, des Trägergasflusses durch die Selen-quelle und der Selentiegeltemperatur kann der Selen-Partialdruck in der Kammer z.B. mittels eines Computers ermittelt werden und an die Regelung für die Selenquelle übergeben werden. Diese regelt dann den Fluss des Trägergases 118, die Tiegel-, Quellenwand- sowie Zu- und Ableitungsrohr-Temperaturen unter Berücksichtigung der Dampfdruckkurve nach. Eine hinreichende Bedingung zur Vermeidung von Selenkondensation ist z.B., dass die Selen-Quellentemperatur (Kurve A in Fig. 3) nicht größer als die Temperatur in der Prozesskammer 14 ist und insbesondere nicht größer als eine minimale Substrattemperatur (Kurve B in Fig. 3) ist.

Um den Bandabstand des I-III-VI-Verbindungshalbleiters gezielt zu beeinflussen und dadurch den Wirkungsgrad des Solarmodules zu erhöhen, kann bereits in dieser Phase dem Selenfluss durch Zuschalten der Schwefelquelle Schwefel so zugeführt werden, dass sich ein Partialdruck-Verhältnis von Selen zu Schwefel zwischen 0 und 0,9, bevorzugt zwischen 0,1 und 0,3 einstellt. Die Regelung der Schwefelquelle erfolgt dabei analog zur beschriebenen Regelung der Selenquelle. Nachdem das Prozessgas 44 für eine bestimmte Zeitdauer bei einem Prozesskammerdruck im Bereich von z.B. 100 mbar bis Umgebungsdruck, bevorzugt zwischen 700 mbar und 950 mbar, einem gewünschten Temperaturprofil (Fig. 3), einer gewünschten Gasströmungsgeschwindigkeit und den gewünschten Selen- bzw. Schwefel-Partialdrücken, z.B. im Bereich von 0,001 mbar bis 100 mbar, über die Substrate 12 hinweggeströmt ist, werden die Zufuhr von elementarem Selen- und Schwefeldampf gestoppt, eventuell die Ventilatoren 46, 50 abgeschaltet und die Prozesskammer 14 mindestens einmal evakuiert und/oder gespült. Alternativ kann lediglich die Zufuhr des Selendampfes gestoppt werden. Die Selen-Quellentemperatur wird währenddessen wieder auf ihre Grundtemperatur von zum Beispiel 150°C bis 300°C abgesenkt.

Anschließend wird das der Quelle 104 für elementaren Schwefeldampf zugeordnete Ventil 108 geöffnet und der mit dem Trägergas 118 vermischte elementare Schwefeldampf als Prozessgas 44 durch die Gaseinlasseinrichtung 42 in die Prozesskammer 14 eingeleitet. Im Alternativbetrieb bleibt das Ventil 108 geöffnet. Gleichzeitig werden die Ventilatoren 46, 50 wieder eingeschaltet, falls sie vorher ausgeschaltet wurden. Die Prozesstemperatur wird weiter erhöht, z.B. auf zwischen 400°C und 600°C, und für eine bestimmte Zeitdauer auf einer Solltemperatur gehalten (Fig. 3). Bei einem Prozesskammerdruck im Bereich von Grobvakuum, Umgebungsdruck oder Überdruck werden die gewünschte Gasströmungsgeschwindigkeit und Schwefelkonzentration eingeregelt, letztere z.B. im Bereich von 0,01 mbar bis 100 mbar.

Auch bei diesem Prozessschritt wird die Bedingung eingehalten, dass der Schwefelpartialdruck in der Prozesskammer den Schwefeldampfdruck bei der entsprechenden Substrattemperatur nicht überschritten wird, um Schwefelkondensation zu vermeiden. Die in der Beschreibung für die Selenquelle aufgestellten Regeln und Maßnahmen gelten hier analog. Auch hier ist eine hinreichende Maßnahme, dass die Schwefel-Quellentemperatur (Kurve C in Fig. 3) nicht größer als die Temperatur in der Prozesskammer 14 ist und insbesondere nicht größer als eine minimale Substrattemperatur (Kurve B in Fig. 3) ist. Die Schwefel-Quellentemperatur wird hierzu z.B. im Temperaturbereich zwischen 100°C und 450°C, bevorzugt zwischen 150°C und 350°C gehalten oder nachgeführt.

Nach Beendigung des Heizvorgangs werden die oberen Gasumlenkelemente 54 in ihre geschlossene Stellung gebracht und die unteren Gasumlenkelemente 56 geöffnet, sodass das Prozessgas 44 nun durch die Kühleinrichtung 40 geleitet wird und eine Abkühlung der Substrate 12 auf eine Temperatur beispielsweise im Bereich von 350°C bis 150°C, beispielsweise 250°C, erfolgt.

Nach einem erneuten Abpumpen der Prozesskammer 14 und Befüllung mit Stickstoff ist die Prozessierung des Substratstapels 66 abgeschlossen, sodass dieser aus der Prozesskammer 14 entnommen werden kann.

Die mit der Prozessvorrichtung 10 erreichbaren und in einem weiten Bereich - beispielsweise von 5°C/min bis 600°C/min - einstellbaren Aufheiz-und Abkühlraten ermöglichen es, die Prozessierung des Substratstapels 66 in der Prozesskammer 14, d.h. im vorliegenden Ausführungsbeispiel die Selenisierung und Sulfurisierung der metallbeschichteten Glassubstrate 12, in weniger als 2 Stunden durchzuführen.

Grundsätzlich ist es möglich, den Prozessgutstapel 66 durch die Beladungsöffnung 60 an der Vorderseite 58 der Prozessvorrichtung 10 zu entnehmen.

Im vorliegenden Ausführungsbeispiel weist die Prozessvorrichtung 10 an ihrer Rückseite 68 jedoch eine in die Prozesskammerwand 16 eingelassene Entladungsöffnung 70 auf, die ähnlich wie die Beladungsöffnung 60 durch ein Plattenventil 72 oder eine andere geeignete Tür verschließbar ist (Fig. 4). Die Ausrüstung der Prozessvorrichtung 10 mit einer Beladungsöffnung 60 und einer gegenüberliegenden Entladungsöffnung 70 hat den Vorteil, dass die Prozessvorrichtung 10 als Durchlaufvorrichtung verwendet und mit weiteren Bearbeitungsvorrichtungen gekoppelt werden kann.

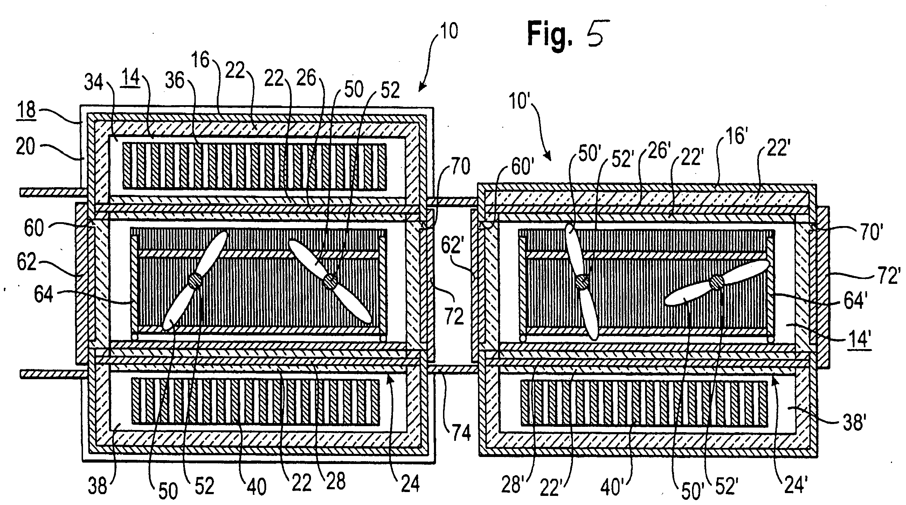

In Fig. 5 ist beispielsweise eine Prozessanlage gezeigt, die eine Prozessvorrichtung 10 und eine ausgangsseitig daran angeschlossene Abkühlvorrichtung 10' umfasst. Die Abkühlvorrichtung 10' ist ähnlich wie die Prozessvorrichtung 10 ausgebildet mit dem einzigen Unterschied, dass der obere Kammerbereich 34 mit der darin angeordneten Heizeinrichtung 36 fehlt. Da die Abkühlvorrichtung 10' ausschließlich zum Abkühlen der Glassubstrate 12 vorgesehen ist und ein Kühlgas, insbesondere ein Inertgas, wie z.B. Stickstoffgas, ausschließlich durch die Gasleiteinrichtung 24' und den die Kühleinrichtung 40' umfassenden unteren Kammerbereich 38' strömen soll, fehlen außerdem die oberen und unteren Gasumlenkelemente 54, 56. Der besseren Übersichtlichkeit halber sind in Fig. 5 keine zweiten Verteilereinrichtungen 32 dargestellt.

Die Abkühlvorrichtung 10' ist über einen Verbindungsabschnitt 74 mit der Prozessvorrichtung 10 gekoppelt und derart neben dieser angeordnet, dass eine Beladungsöffnung 60' der Abkühlvorrichtung 10' mit der Entladungsöffnung 70 der Prozessvorrichtung 10 ausgerichtet ist. Die Beladungsöffnung 60' der Abkühlvorrichtung 10' kann durch ein Plattenventil 62' gleichzeitig mit oder unabhängig von der Entladungsöffnung 70 der Prozessvorrichtung 10 geöffnet und geschlossen werden.

Durch die Anordnung der Prozessvorrichtung 10 und der Abkühlvorrichtung 10' in Reihe ist es möglich, den Prozessgutstapel 66 nach beendeter Prozessierung in der Prozessvorrichtung 10 durch die Entladungsöffnung 70 und die Beladungsöffnung 60' in die Abkühlvorrichtung 74 zu bewegen. Das Ausschleusen des Prozessgutstapels 66 aus der Prozessvorrichtung 10 in die Abkühlvorrichtung 74 kann beispielsweise bei einer Temperatur im Bereich von 400°C bis 200°C, insbesondere von 300°C bis 250°C, erfolgen.

Nach dem Einbringen des Prozessgutstapels 66 in die Abkühlvorrichtung 10' wird das Plattenventil 72 wieder geschlossen und die Prozessvorrichtung 10 mit einem neuen Prozessgutstapel 66 bestückt.

Gleichzeitig kann der erste Prozessgutstapel 66, der sich nun in der Abkühlvorrichtung 10' befindet, noch weiter abgekühlt werden, z.B. bis auf 80°C, indem durch Betätigung der Ventilatoren 50' zirkulierendes Stickstoffgas an den Glassubstraten 12 vorbei und durch die Kühleinrichtung 40' geleitet wird. Nach einer abschließenden Evakuierung und letzten Befüllung der Abkühlvorrichtung 10' kann der Prozessgutstapel 66 durch eine Entladungsöffnung 70' aus der Abkühlvorrichtung 10' entnommen werden. Die Abkühlvorrichtung 10' ist nun zur Aufnahme des nächsten Prozessgutstapels 66 aus der Prozessvorrichtung 10 bereit.

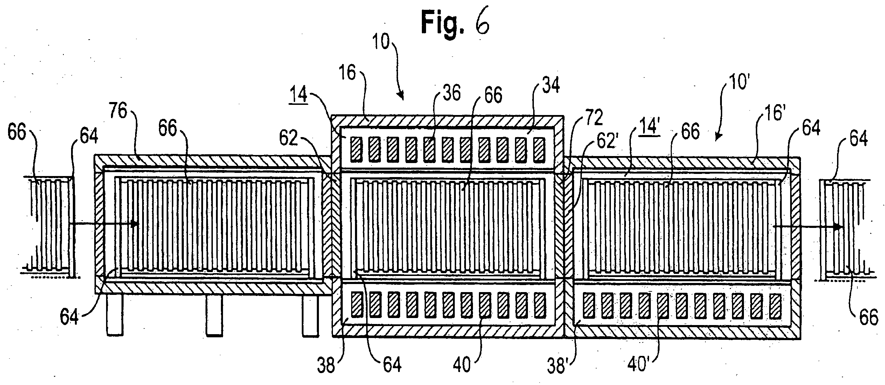

Wie in Fig. 6 gezeigt ist, kann der Prozessvorrichtung 10 eine Einschleuskammer 76 vorgelagert sein, durch welche verhindert wird, dass bei der Beladung der Prozessvorrichtung 10 mit einem Prozessgutstapel 66 Umgebungsatmosphäre in die Prozesskammer 14 eindringt. In der Einschleuskammer 76 kann der Prozessgutstapel 66 von Raumtemperatur auf eine Temperatur im Bereich von 100°C bis 200°C, z.B. etwa 150°C vorgeheizt werden.

Ferner kann ein Transportmechanismus zur Bewegung des den Prozessgutstapel 66 tragenden Trägers 64 durch die Prozessanlage eine Einschiebemechanik zum Einschieben des Trägers 64 und Prozessgutstapels 66 aus der Einschleuskammer 76 in die Prozesskammer 14 sowie eine Herausziehmechanik zum Herausziehen des Trägers 64 und Prozessgutstapels 66 aus der Prozesskammer 14 in die Abkühlvorrichtung 10' umfassen. Auf diese Weise kann verhindert werden, dass die bewegten Teile des Transportmechanismus mit den heißen und korrosiven Bereichen der Prozessanlage in Kontakt gelangen.

### Bezugszeichenliste

- 10: Prozessvorrichtung
- 12: Substrat
- 14: Prozesskammer
- 16: Prozesskammerwand
- 18: Temperiereinrichtung
- 20: Rohrleitung
- 22: thermisches Isolationsmaterial
- 24: Gasleiteinrichtung
- 26: obere Trennplatte
- 28: untere Trennplatte
- 30: erste Verteilereinrichtung
- 32: zweite Verteilereinrichtung
- 33: Schlitze
- 34: oberer Kammerbereich
- 35: Gasstrom
- 36: Heizeinrichtung
- 38: unterer Kammerbereich
- 40: Kühleinrichtung
- 42: Gaseinlasseinrichtung
- 44: Prozessgas
- 46: erster Ventilator
- 48: erste Antriebswelle
- 50: zweiter Ventilator
- 52: zweite Antriebswelle
- 54: oberes Gasumlenkelement
- 56: unteres Gasumlenkelement
- 60: Beladungsöffnung
- 62: Plattenventil
- 64: Träger
- 66: Prozessgutstapel
- 68: Rückseite
- 70: Entladungsöffnung
- 72: Plattenventil
- 74: Verbindungsabschnitt
- 76: Einschleuskammer
- 100: Zuführleitung
- 102: Quelle für elementaren Selendampf
- 104: Quelle für elementaren Schwefeldampf
- 106: Ventil
- 108: Ventil
- 110: Quellenkammer
- 112: Selenschmelze
- 114: Tiegel
- 116: Leitung
- 118: Trägergas
- 120: Schwefelschmelze
- 122: Quellenkammerwand
- 124: Temperiereinrichtung
- 126: Temperiereinrichtung

## Patentansprüche

1. Verfahren zum Herstellen einer Halbleiterschicht, bei dem wenigstens ein mit einer Metallschicht versehenes Substrat (12) in eine Prozesskammer (14) eingebracht und auf eine vorbestimmte Substrattemperatur erwärmt wird, **dadurch gekennzeichnet, dass** elementarer Selen- und/oder Schwefeldampf von einer, vorzugsweise außerhalb der Prozesskammer (14) gelegenen Quelle (102, 104) mittels eines, insbesondere inerten, Trägergases (118) unter Grobvakuumbedingungen oder Umgebungsdruckbedingungen oder Überdruckbedingungen an der Metallschicht vorbeigeleitet wird, um diese mit Selen bzw. Schwefel gezielt chemisch zu reagieren, dass das Substrat (12) mittels erzwungener Konvektion durch eine Gasfördereinrichtung, insbesondere einen Ventilator, erwärmt wird und der elementare Selen- und/ oder Schwefeldampf mittels erzwungener Konvektion durch die Gasfördereinrichtung im Prozessraum homogen vermischt und an dem Substrat (12) vorbeigeleitet wird, wobei eine Heizeinrichtung (36) in dem von der Gasfördereinrichtung in der Prozesskammer erzeugten Gasströmungskreislauf angeordnet wird, um das in der Prozesskammer (14) befindliche Gas aufzuheizen.

2. Verfahren zum Herstellen einer Halbleiterschicht nach Anspruch 1, bei dem ein Stapel (66) von jeweils mit einer Metallschicht versehenes Substrat (12) in eine Prozesskammer (14) eingebracht und auf eine vorbestimmte Substrattemperatur erwärmt wird; und elementarer Selen- und/oder Schwefeldampf von einer außerhalb der Prozesskammer (14) gelegenen Quelle (102, 104) mittels eines inerten Trägergases (118) unter Grobvakuumbedingungen oder Umgebungsdruckbedingungen oder Überdruckbedingungen an jeder Metallschicht vorbeigeleitet wird, um diese mit Selen bzw. Schwefel gezielt chemisch zu reagieren, **dadurch gekennzeichnet, dass** das Substrat (12) mittels erzwungener Konvektion durch die Gasfördereinrichtung, insbesondere den Ventilator erwärmt wird und der elementare Selen- und/ oder Schwefeldampf mittels erzwungener Konvektion durch die Gasfördereinrichtung im Prozessraum homogen vermischt und an dem Substrat (12) vorbeigeleitet wird.

3. Verfahren nach Anspruch 1 oder 2, **dadurch gekennzeichnet, dass** die Quelle (102, 104) auf einer erhöhten Quellentemperatur gehalten wird, oder auf eine erhöhte Quellentemperatur nachgeführt wird, welche vorzugsweise zu jedem Zeitpunkt des Vorbeileitens des elementaren Selen- und/oder Schwefeldampfes an dem Substrat (12) kleiner als die Temperatur in der Prozesskammer (14) und kleiner als eine minimale Substrattemperatur ist.

4. Verfahren nach einem der vorstehenden Ansprüche, **dadurch gekennzeichnet, dass** eine Zufuhrleitung (100), durch die der elementare Selen- und/ oder Schwefeldampf auf dem Weg von der Quelle (102, 104) zu dem Substrat (12) geleitet wird, und/oder eine die Prozesskammer (14) definierende Wand (16) auf einer Temperatur gehalten werden bzw. wird, die gleich oder größer als die Temperatur der Quelle (102, 104) ist.

5. Verfahren nach einem der vorstehenden Ansprüche, **dadurch gekennzeichnet, dass** als Quelle (102, 104) ein flüssiges Selen oder flüssigen Schwefel aufweisender Bubbler, durch den das Trägergas (118) geleitet wird, und/oder ein mit flüssigem Selen oder Schwefel gefüllter Tiegel (1 14) verwendet wird, welcher eine Verdampfung des Selens oder Schwefels ermöglichende Seite aufweist, an der das Trägergas (118) vorbei geleitet wird.

6. Verfahren nach einem der vorstehenden Ansprüche, **dadurch gekennzeichnet, dass** die chemische Reaktion des Selens und/oder des Schwefels mit der Metallschicht bei einem Totaldruck in der Prozesskammer (14) im Bereich von Grobvakuumbedingungen oder Umgebungsdruckbedingungen oder Überdruckbedingungen und/oder bei einem Selen- oder Schwefeldampf-Partialdruck im Bereich von etwa 0,001 mbar bis etwa 100 mbar durchgeführt wird.

7. Verfahren nach einem der vorstehenden Ansprüche, **gekennzeichnet durch** die Schritte:
- Erhöhen der Substrattemperatur mit einer Aufheizrate von etwa 5°C/min bis 600°C/min, bevorzugt 10°C/min bis 60°C/ min, von Raumtemperatur auf eine Temperatur im Bereich von etwa 400°C bis 600°C, bevorzugt 400°C bis 500°C;
- Zuführen von elementarem Selendampf in die Prozesskammer ab einer Substrattemperatur zwischen 120°C und 300°C und dabei Nachführen der Selenquellentemperatur auf einen gewünschten Partialdruck, bevorzugt zwischen 0,001 mbar und 100 mbar;
- Halten der Substrattemperatur im Bereich von 400°C bis 600°C für 1 min bis 60 min, bevorzugt für 10 min bis 30 min;
- Abschalten der Zuführung von elementarem Selen- und gegebenenfalls Schwefeldampf in die Prozesskammer nach einer ersten vorbestimmten Zeitdauer;
- mindestens einmaliges Abpumpen und/öder Spülen der Prozesskammer;
- Zufuhren von elementarem Schwefeldampf in die Prozesskammer;
- weiteres Erhöhen der Substrattemperatur mit einer Aufheizrate von etwa 5°C/min bis 600°C/min, bevorzugt 10°C/min bis 60°C/min, auf eine Temperatur im Bereich von etwa 450°C bis 650°C, bevorzugt 500°C bis 550°C, und dabei Nachführen der Schwefelquellentemperatur auf einen gewünschten Partialdruck, bevorzugt zwischen 0,001 mbar und 100 mbar;
- Halten der Substrattemperatur im Bereich von 450°C bis 650°C für 1 min bis 60 min, bevorzugt für 10 min bis 30 min;
- Abschalten der Zuführung von elementarem Schwefeldampf in die Prozesskammer nach einer zweiten vorbestimmten Zeitdauer;
- Abkühlen des Substrats; und
- Abpumpen und/ oder Spülen der Prozesskammer.

8. Verfahren nach einem der vorstehenden Ansprüche, **dadurch gekennzeichnet, dass** während des Selenisierungsschritts, z.B. ab einer Substrattemperatur von 120°C bis 600°C, elementarer Schwefeldampf in die Prozesskammer zugeführt wird, derart, dass sich ein Partialdruck-Verhältnis von Selen zu Schwefel zwischen 0 und 0,9, bevorzugt zwischen 0,1 und 0,3, einstellt.

9. Verfahren nach einem der Ansprüche 1 bis 6, **dadurch gekennzeichnet, dass** die Metallschicht wenigstens eines der Elemente In, Zn oder Mg aufweist und/oder die herzustellende Halbleiterschicht eine Pufferschicht, eine In2S3-, ZnSe-, ZnS-, Zn(S,OH)- oder (ZnMg)O-Schicht, ist.

10. Verfahren nach Anspruch 9, **dadurch gekennzeichnet, dass** dem den Selen- und/oder Schwefeldampf enthaltenden Trägergas (118) mindestens ein reaktives Gas, z.B. Sauerstoff oder Wasserstoff, beigemischt wird.

11. Prozessvorrichtung (10) zur Durchführung eines Verfahrens nach einem der vorherigen Ansprüche mit einer evakuierbaren Prozesskammer (14) zur Aufnahme wenigstens eines zu prozessierenden Substrats (12), einer Heizeinrichtung (36) zum konvektiven Erwärmen des zu prozessierenden Substrats (12), einer außerhalb der Prozesskammer (14) gelegenen und durch eine Zufuhrleitung (1 00) mit der Prozesskammer (14) verbundenen Quelle (102, 104) für elementaren Selen- und/ oder Schwefeldampf, und einer Temperiereinrichtung (18, 126), um zumindest einen Teilbereich einer die Prozesskammer (14) definierenden Wand (16) und zumindest einen Abschnitt der Zufuhrleitung (100) jeweils auf einer vorgegebenen Temperatur zu halten, **gekennzeichnet durch** eine Gasfördereinrichtung zum Erzeugen eines Gasströmungskreislaufes in der Prozesskammer (14), wobei die Gasfördereinrichtung bevorzugt wenigstens einen Ventilator (46, 50) umfasst, der bevorzugt im Bereich einer der Stirnseiten des Substrats (12) angeordnet ist.

12. Prozessvorrichtung (10) zur Durchführung eines Verfahrens nach Anspruch 11 mit einer evakuierbaren Prozesskammer (14) zur Aufnahme eines Stapels (66) von zu prozessierenden Substraten (12), einer Heizeinrichtung (36) zum konvektiven Erwärmen des zu prozessierenden Substrats (12), einer außerhalb der Prozesskammer (14) gelegenen und durch eine Zufuhrleitung (1 00) mit der Prozesskammer (14) verbundenen Quelle (102, 104) für elementaren Selen- und/ oder Schwefeldampf, und einer Temperiereinrichtung (18, 126), um zumindest einen Teilbereich einer die Prozesskammer (14) definierenden Wand (16) und zumindest einen Abschnitt der Zufuhrleitung (100) jeweils auf einer vorgegebenen Temperatur zu halten, **gekennzeichnet durch** eine Gasfördereinrichtung zum Erzeugen eines Gasströmungskreislaufes in der Prozesskammer (14), wobei die Gasfördereinrichtung bevorzugt wenigstens einen Ventilator (46, 50) umfasst, der bevorzugt im Bereich einer der Stirnseiten des Substratstapels (66) angeordnet ist.

13. Vorrichtung nach Anspruch 11 oder 12, **dadurch gekennzeichnet, dass** die Quelle (102, 104) eine beheizbare und evakuierbare Quellenkammer (110), in der ein mit Selen- oder Schwefelschmelze gefüllter Tiegel (114) angeordnet ist, und eine Leitung (116) für vorgewärmtes Trägergas (1 18) derart umfasst, dass das Trägergas (118) entweder nach dem Prinzip eines Bubblers durch die Selen oder Schwefelschmelze (112, 120) hindurch geleitet wird oder über eine Oberfläche der Selen- oder Schwefelschmelze (112, 120) hinweggeleitet wird, wobei der Tiegel (114) und die Leitung (116) ein in Selen oder Schwefel reaktionsbeständiges Material aufweisen und z.B. aus Keramik, Quarz oder korrosionsbeständigen Speziallegierungen oder Metallen mit korrosionsbeständigen Beschichtungen gebildet sind.

14. Vorrichtung nach einem der Ansprüche 11 bis 13, **dadurch gekennzeichnet, dass** die Heizeinrichtung (36) in dem von der Gasfördereinrichtung erzeugten Gasströmungskreislauf angeordnet ist, um ein in der Prozesskammer (14) befindliches Gas aufzuheizen; und/oder eine Kühleinrichtung (40) zum Abkühlen eines in der Prozesskammer (14) befindlichen Gases in dem von der Gasfördereinrichtung erzeugten Gasströmungskreislauf angeordnet ist; und/oder Gasumlenkelemente (54, 56) vorgesehen sind, durch die der Gasströmungskreislauf derart umlenkbar ist, dass entweder die Heizeinrichtung (36) oder eine Kühleinrichtung (40) in dem Gasströmungskreislauf angeordnet ist.

15. Prozessanlage zum Prozessieren von gestapelten Substraten (12) mit mindestens einer Prozessvorrichtung (10) nach einem der Ansprüche 11 bis 14, **dadurch gekennzeichnet, dass** die Prozessvorrichtung (10) eine Beladungsöffnung (60), durch die der Substratstapel (66) in die Prozesskammer (14) einbringbar ist, und eine Entladungsöffnung (70) aufweist, durch die der Substratstapel (66) aus der Prozesskammer (14) entnehmbar ist.

## Claims

1. A method for producing a semiconductor layer in which at least one substrate (12) provided with a metal layer is inserted into a process chamber (14) and heated to a predetermined substrate temperature, **characterized in that** elementary selenium and/or sulfur vapor from a source (102, 104) which is preferably located outside the process chamber (14) is conducted using a, particularly an inert, carrier gas (118) under rough vacuum or ambient pressure or overpressure conditions past said metal layer for a targeted chemical reaction thereof with selenium or sulfur, respectively, **in that** the substrate (12) is heated by forced convection by means of a gas supply facility, particularly a fan, and the elementary selenium and/or sulfur vapor is homogeneously intermixed by forced convection by means of the gas supply facility in the process space and conducted past the substrate (12), wherein a heating unit (36) is disposed in the gas flow circulation generated in the process chamber by the gas supply facility to heat up the gas in the process chamber (14).

2. The method for producing a semiconductor layer according to claim 1, in which a stack (66) of substrates (12) provided with one metal layer each is inserted into a process chamber (14) and heated to a predetermined substrate temperature; and elementary selenium and/or sulfur vapor from a source (102, 104) located outside the process chamber (14) is conducted using an inert carrier gas (118) under rough vacuum or ambient pressure or overpressure conditions past each metal layer for a targeted chemical reaction thereof with selenium or sulfur, **characterized in that** the substrate (12) is heated by forced convection by means of the gas supply facility, particularly the fan, and the elementary selenium and/or sulfur vapor is homogeneously intermixed by forced convection by means of the gas supply facility in the process space and conducted past the substrate (12).

3. The method according to claim 1 or 2, **characterized in that** the source (102, 104) is kept at an increased source temperature or controlled to be heated to an increased source temperature, which at the time of conducting the elementary selenium and/or sulfur vapor past the substrate (12) is lower than the temperature in the process chamber (14) and lower than a minimum substrate temperature.

4. The method according to any one of the preceding claims, **characterized in that** a supply line (100) through which the elementary selenium and/ or sulfur vapor is conducted on its way from the source (102, 104) to the substrate (12), and/or a wall (16) that defines the process chamber (14) are/is kept at a temperature that is the same as, or higher than, the temperature of the source (102, 104).

5. The method according to any one of the preceding claims, **characterized in that** the source (102, 104) used is a bubbler comprising liquid selenium or liquid sulfur through which carrier gas (118) is conducted and/or a crucible (114) filled with liquid selenium or sulfur, which comprises a side that allows the evaporation of the selenium or sulfur and past which the carrier gas (118) is conducted.

6. The method according to any one of the preceding claims, **characterized in that** the chemical reaction of the selenium and/or sulfur with the metal layer is performed at a total pressure in the process chamber (14) in the range of rough vacuum, ambient pressure, or overpressure conditions and/or at a partial selenium or sulfur vapor pressure in the range from about 0.001 mbar to about 100 mbar.

7. The method according to any one of the preceding claims, **characterized by** the following steps:
- Increasing the substrate temperature at a heating rate from about 5°C/min to 600°C/min, preferably 10°C/min to 60°C/min, from room temperature to a temperature in the range from about 400°C to 600°C, preferably 400°C to 500°C;
- Supplying elementary selenium vapor to the process chamber from a substrate temperature between 120°C and 300°C, adjusting the selenium source temperature to a desired partial pressure, preferably between 0.001 mbar and 100 mbar;
- Keeping the substrate temperature in the range from 400°C to 600°C for 1 min to 60 min, preferably for 10 min to 30 min;
- Switching off the supply of elementary selenium and, optionally, sulfur vapor to the process chamber after a first predetermined period of time;
- At least one-time draining and/or flushing of the process chamber;
- Supplying elementary sulfur vapor to the process chamber;
- Further increase of the substrate temperature at a heating rate of about 5°C/min to 600°C/min, preferably 10°C/min to 60°C/min, to a temperature in the range from about 450°C to 650°C, preferably 500°C to 550°C, and also adjusting the sulfur source temperature to a desired partial pressure, preferably between 0.001 mbar and 100 mbar;
- Keeping the substrate temperature in the range from 450°C to 650°C for 1 min to 60 min, preferably for 10 min to 30 min;
- Switching off the supply of elementary sulfur vapor to the process chamber after a second predetermined period of time;
- Cooling down the substrate; and
- Draining and/or flushing of the process chamber.

8. The method according to any one of the preceding claims, **characterized in that** in the selenization step, e.g. from a substrate temperature of 120°C to 600°C, elementary sulfur vapor is supplied to the process chamber such that a selenium to sulfur partial pressure ratio is achieved between 0 and 0.9, preferred between 0. 1 and 0.3.

9. The method according to any one of claims 1 to 6, **characterized in that** the metal layer comprises at least one of the elements In, Zn, or Mg and/or that the semiconductor layer to be produced is a buffer layer, an In2S3, ZnSe, ZnS, Zn(S,OH), or (ZnMg)O layer.

10. The method according to claim 9, **characterized in that** at least one reactive gas, such as oxygen or hydrogen, is admixed with the selenium- and/or sulfurcontaining carrier gas (118).

11. A process device (10) for performing a method according to any one of the preceding claims comprising an evacuable process chamber (14) for receiving at least one substrate (12) to be processed, a heating unit (36) for convective heating of the substrate (12) to be processed, a source (102, 104) of elementary selenium and/or sulfur vapor, which is located outside said process chamber (14) and connected to said process chamber (14) via a supply line (100), and a temperature control device (18, 126) to keep at least a partial region of the wall (16) that defines the process chamber (14) and at least a section of the supply line (100) each at a predetermined temperature, **characterized by** a gas supply facility for generating a gas flow circulation in the process chamber (14), wherein said gas supply facility preferably includes at least one fan (46, 50) which is preferably provided in the region of one of the front ends of the substrate (12).

12. The process device (10) for performing a method according to claim 11 comprising an evacuable process chamber (14) for receiving a stack (66) of substrates (12) to be processed, a heating unit (36) for convective heating of the substrate (12) to be processed, a source (102, 104) of elementary selenium and/or sulfur vapor, which is located outside said process chamber (14) and connected to said process chamber (14) via a supply line (100), and a temperature control device (18, 126) to keep at least a partial region of the wall (16) that defines the process chamber (14) and at least a section of the supply line (100) at a predetermined temperature, **characterized by** a gas supply facility for generating a gas flow circulation in the process chamber (14), wherein said gas supply facility preferably includes at least one fan (46, 50) which is preferably provided in the region of one of the front ends of the substrate stack (66).

13. The device according to claim 11 or 12, **characterized in that** the source (102, 104) comprises a source chamber (110) that can be heated and evacuated and in which a crucible (114) filled with molten selenium or sulfur is located and which includes a line (116) for preheated carrier gas (118) such that said carrier gas (118) is either conducted through the molten selenium or sulfur (112, 120) in accordance with the bubbler principle or is conducted across the surface of the molten selenium or sulfur (112, 120), wherein the crucible (114) and the line (116) comprise a material that is resistant to reaction with selenium or sulfur, e.g. are made of ceramic, quartz, corrosion-resistant special metal alloys or metals with corrosion-resistant coatings.

14. The device according to any one of claims 11 to 13, **characterized in that** the heating unit (36) is disposed in the gas flow circulation produced by the gas supply facility to heat up any gas present in the process chamber (14); and/or a cooling unit (40) for cooling down a gas located in the gas flow circulation produced by the gas supply facility in the process chamber (14); and/or elements for redirecting gas (54, 56) are provided by means of which the gas flow can be redirected such that either the heating unit (36) or a cooling unit (40) is placed in the gas flow circulation.

15. A processing plant for processing stacked substrates (12) comprising at least one process device (10) according to any one of claims 11 to 14, **characterized in that** the process device (10) comprises a loading opening (60) through which the substrate stack (66) can be introduced into the process chamber (14), and comprises a discharge opening (70) through which the substrate stack (66) can be removed from the process chamber (14).

## Revendications

1. Procédé de fabrication d'une couche semi-conductrice, dans lequel au moins un substrat (12) muni d'une couche métallique est mis en place dans une chambre de traitement (14) et est chauffé à une température de substrat prédéfinie, **caractérisé en ce que** de la vapeur de sélénium et/ou de soufre élémentaire provenant d'une source (102, 104) située de préférence à l'extérieur de la chambre de traitement (14) est amenée, au moyen d'un gaz porteur (118) en particulier inerte, en présence de conditions de vide grossier ou de conditions de pression ambiante ou de conditions de surpression, à passer devant la couche métallique afin de faire réagir chimiquement cette dernière de façon ciblée avec le sélénium ou le soufre, **en ce que** le substrat (12) est chauffé au moyen d'une convection forcée par un dispositif d'alimentation en gaz, en particulier par un ventilateur, et la vapeur de sélénium et/ou de soufre élémentaire est mélangée de façon homogène dans le compartiment de traitement au moyen d'une convection forcée par le dispositif d'alimentation en gaz et est amenée à passer devant le substrat (12), un dispositif de chauffage (36) étant disposé dans le circuit d'écoulement gazeux produit dans la chambre de traitement par le dispositif d'alimentation en gaz afin de chauffer le gaz présent dans la chambre de traitement (14).

2. Procédé de fabrication d'une couche semi-conductrice selon la revendication 1, dans lequel une pile (66) de substrat (12) muni respectivement d'une couche métallique est mise en place dans une chambre de traitement (14) et est chauffée à une température de substrat prédéfinie ; et de la vapeur de sélénium et/ou de soufre élémentaire provenant d'une source (102, 104) située à l'extérieur de la chambre de traitement (14) est amenée, au moyen d'un gaz porteur (118) inerte, en présence de conditions de vide grossier ou de conditions de pression ambiante ou de conditions de surpression, à passer devant chaque couche métallique afin de faire réagir chimiquement de façon ciblée chaque couche métallique avec le sélénium ou respectivement le soufre, **caractérisé en ce que** le substrat (12) est chauffé au moyen d'une convection forcée par le dispositif d'alimentation en gaz, en particulier par le ventilateur, et la vapeur de sélénium et/ou de soufre élémentaire est mélangée de façon homogène dans le compartiment de traitement au moyen d'une convection forcée par le dispositif d'alimentation en gaz et est amenée à passer devant le substrat (12).

3. Procédé selon la revendication 1 ou 2, **caractérisé en ce que** la source (102, 104) est maintenue à une température de source élevée ou bien est réglée à une température de source élevée qui, de préférence à chaque moment du passage de la vapeur de sélénium et/ou de soufre élémentaire devant le substrat (12), est inférieure à la température dans la chambre de traitement (14) et inférieure à une température de substrat minimale.

4. Procédé selon une des revendications précédentes, **caractérisé en ce qu'**une conduite d'alimentation (100) à travers laquelle la vapeur de sélénium et/ou de soufre élémentaire est conduite sur le trajet allant de la source (102, 104) au substrat (12), et /ou une paroi (16) définissant la chambre de traitement (14) est/sont maintenue(s) à une température qui est égale ou supérieure à la température de la source (102, 104).

5. Procédé selon une des revendications précédentes, **caractérisé en ce que**, en tant que source (102, 104), on utilise un barboteur présentant du sélénium liquide ou du soufre liquide et à travers lequel le gaz porteur (118) est conduit, et/ou un creuset (114) rempli de sélénium ou de soufre liquide qui présente un côté permettant l'évaporation du sélénium ou du soufre et devant lequel le gaz porteur (118) est amené à passer.

6. Procédé selon une des revendications précédentes, **caractérisé en ce que** la réaction chimique du sélénium et/ou du soufre avec la couche métallique s'effectue en présence d'une pression totale dans la chambre de traitement (14) dans la plage de conditions de vide grossier ou de conditions de pression ambiante ou de conditions de surpression et/ou en présence d'une pression partielle de vapeur de sélénium ou de soufre dans la plage d'environ 0,001 mbar à environ 100 mbar.

7. Procédé selon une des revendications précédentes, **caractérisé par** les étapes suivantes :
- Augmentation de la température de substrat, à un rythme de chauffage d'environ 5 °C/min à 600 °C/min, de préférence de 10 °C/min à 60 °C/min, de la température ambiante à une température dans la plage d'environ 400 °C à 600 °C, de préférence de 400 °C à 500 °C ;
- acheminement de vapeur de sélénium élémentaire dans la chambre de traitement à partir d'une température de substrat entre 120 °C et 300 °C et en l'occurrence réglage de la température de la source de sélénium à une pression partielle souhaitée, de préférence entre 0,001 mbar et environ 100 mbar ;
- maintien de la température de substrat dans la plage de 400 °C à 600 °C pendant 1 minute à 60 minutes, de préférence pendant 10 minutes à 30 minutes ;
- arrêt de l'acheminement de vapeur de sélénium et dans le cas échéant de soufre élémentaire dans la chambre de traitement après une première période de temps prédéfinie ;
- au moins une opération de pompage et/ou de lavage de la chambre de traitement ;
- acheminement de vapeur de soufre élémentaire dans la chambre de traitement ;
- augmentation supplémentaire de la température de substrat, à un rythme de chauffage d'environ 5 °C/min à 600 °C/min, de préférence de 10 °C/min à 60 °C/min, jusqu'à une température dans la plage d'environ 450 °C à 650 °C, de préférence de 500 °C à 550 °C et en l'occurrence réglage de la température de source de soufre à une pression partielle souhaitée, de préférence entre 0,001 mbar et 100 mbar ;
- maintien de la température de substrat dans la plage de 450 °C à 650 °C pendant 1 minute à 60 minutes, de préférence pendant 10 minutes à 30 minutes ;
- arrêt de l'acheminement de vapeur de soufre élémentaire dans la chambre de traitement après une deuxième période de temps prédéfinie ;
- refroidissement du substrat ; et
- pompage et/ou lavage de la chambre de traitement.

8. Procédé selon une des revendications précédentes, **caractérisé en ce que**, pendant l'étape de sélénisation, par ex. à partir d'une température de substrat de 120 °C à 600 °C, de la vapeur de soufre élémentaire est acheminée dans la chambre de traitement de telle façon qu'il s'installe un rapport de pression partielle du sélénium au soufre entre 0 et 0,9, de préférence entre 0,1 et 0,3.

9. Procédé selon une des revendications 1 à 6, **caractérisé en ce que** la couche métallique présente au moins un des éléments In, Zn ou Mg et/ou **en ce que** la couche semi-conductrice à fabriquer est une couche tampon, une couche In2S3, ZnSe, ZnS, Zn(S,OH) ou (ZnMg)O.

10. Procédé selon la revendication 9, **caractérisé en ce qu'**au moins un gaz réactif, par ex. de l'oxygène ou de l'hydrogène, est mélangé au gaz porteur (118) contenant la vapeur de sélénium et/ou de soufre.

11. Dispositif de traitement (10) pour la réalisation d'un procédé selon une des revendications précédentes, avec une chambre de traitement (14) pouvant être vidée destinée à recevoir au moins un substrat (12) à traiter, avec un dispositif de chauffage (36) pour le chauffage par convection du substrat (12) à traiter, avec une source (102, 104), située à l'extérieur de la chambre de traitement (14) et raccordée par une conduite d'alimentation (100) à la chambre de traitement (14), pour de la vapeur de sélénium et/ou de soufre élémentaire, et avec un dispositif d'équilibrage de température (18, 126) pour maintenir respectivement à une température prédéfinie au moins une zone partielle d'une paroi (16) définissant la chambre de traitement (14) et au moins un tronçon de la conduite d'alimentation (100), **caractérisé par** un dispositif d'alimentation en gaz pour la production d'un circuit d'écoulement gazeux dans la chambre de traitement (14), le dispositif d'écoulement gazeux comprenant de préférence au moins un ventilateur (46, 50) qui est disposé de préférence dans la zone d'un des côtés frontaux du substrat (12).

12. Dispositif de traitement (10) pour la réalisation d'un procédé selon la revendication 11, avec une chambre de traitement (14) pouvant être vidée destinée à recevoir une pile (66) de substrats (12) à traiter, avec un dispositif de chauffage (36) pour le chauffage par convection du substrat (12) à traiter, avec une source (102, 104), située à l'extérieur de la chambre de traitement (14) et raccordée par une conduite d'alimentation (100) à la chambre de traitement (14), pour de la vapeur de sélénium et/ou de soufre élémentaire, et avec un dispositif d'équilibrage de température (18, 126) pour maintenir respectivement à une température prédéfinie au moins une zone partielle d'une paroi (16) définissant la chambre de traitement (14) et au moins un tronçon de la conduite d'alimentation (100), **caractérisé par** un dispositif d'alimentation en gaz pour la production d'un circuit d'écoulement gazeux dans la chambre de traitement (14), le dispositif d'écoulement gazeux comprenant de préférence au moins un ventilateur (46, 50) qui est disposé de préférence dans la zone d'un des côtés frontaux de la pile de substrats (66).

13. Dispositif selon la revendication 11 ou 12, **caractérisé en ce que** la source (102, 104) comprend une chambre de source (110), qui peut être chauffée et vidée et dans laquelle est disposé un creuset (114) rempli d'un bain de sélénium ou de soufre, et une conduite (116) pour du gaz porteur (118) préchauffé de telle sorte que le gaz porteur (118) est soit conduit selon le principe d'un barboteur à travers le bain de sélénium ou de soufre (112, 120), soit est conduit par-dessus une surface du bain de sélénium ou de soufre (112, 120), le creuset (114) et la conduite (116) présentant un matériau résistant à la réaction dans le sélénium ou le soufre et étant formés par ex. de céramique, de quartz ou d'alliages spéciaux résistants à la corrosion ou de métaux ayant des revêtements résistants à la corrosion.

14. Dispositif selon une des revendication 11 à 13, **caractérisé en ce que** le dispositif de chauffage (36) est disposé dans le circuit d'écoulement gazeux produit par le dispositif d'écoulement gazeux afin de chauffer un gaz présent dans la chambre de traitement (14) ; et/ou **en ce qu'**un dispositif de refroidissement (40) pour le refroidissement d'un gaz présent dans la chambre de traitement (14) est disposé dans le circuit d'écoulement gazeux produit par le dispositif d'écoulement gazeux ; et/ou **en ce qu'**il est prévu des éléments de déviation du gaz (54, 46) par lesquels le circuit d'écoulement gazeux peut être dévié de telle sorte que soit le dispositif de chauffage (36), soit un dispositif de refroidissement (40) est disposé dans le circuit d'écoulement gazeux.

15. Installation de traitement pour le traitement de substrats (12) empilés avec au moins un dispositif de traitement (10) selon une des revendication 11 à 14, **caractérisée en ce que** le dispositif de traitement (10) présente une ouverture de chargement (60) à travers laquelle la pile de substrats (66) peut être mise en place dans la chambre de traitement (14) et une ouverture de déchargement (70) à travers laquelle la pile de substrats (66) peut être enlevée de la chambre de traitement (14).
